(19) Europäisches Patentamt
European Patent Office
Office européen des brevets

(11) **EP 2 226 643 B1**

(12) **FASCICULE DE BREVET EUROPEEN**

(45) Date de publication et mention de la délivrance du brevet:
**02.11.2011 Bulletin 2011/44**

(51) Int Cl.:
***G01R 33/022*** *(2006.01)*   ***G01R 33/028*** *(2006.01)*

(21) Numéro de dépôt: **10155245.3**

(22) Date de dépôt: **02.03.2010**

(54) **Gradiometre à aimant permanent**

Gradiometer mit Permanentmagneten

Gradiometer with permanent magnet

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **06.03.2009 FR 0951424**

(43) Date de publication de la demande:
**08.09.2010 Bulletin 2010/36**

(73) Titulaires:
- **Commissariat à l'Énergie Atomique et aux Énergies Alternatives 75015 Paris (FR)**
- **Institut Polytechnique de Grenoble 38000 Grenoble (FR)**

(72) Inventeurs:
- **Walther, Arnaud 38000 GRENOBLE (FR)**
- **Cuchet, Robert 38930 MONESTIER DE PERCY (FR)**
- **Delamare, Jérôme 38000 GRENOBLE (FR)**
- **Msaed, Aline 38029 GRENOBLE (FR)**
- **Albertini, Jean-Baptiste 38120 SAINT EGREVE (FR)**

(74) Mandataire: **Ilgart, Jean-Christophe BREVALEX 95 rue d'Amsterdam 75378 Paris Cedex 8 (FR)**

(56) Documents cités:
WO-A1-2005/062064    WO-A2-01/67122
US-A1- 2003 020 472

**Description**

## DOMAINE TECHNIQUE

La présente invention concerne un capteur du gradient d'une composante d'un champ magnétique et un procédé de fabrication de ce capteur en technologie intégrée. En ce qui concerne le champ magnétique, il peut s'agir de l'excitation magnétique H appelée également champ courant ou de l'induction magnétique B, ces deux grandeurs étant liées d'une manière fixe.

Un tel capteur peut être utilisé pour faire des mesures sans contact d'un courant circulant dans un conducteur filiforme. Les domaines d'application d'une telle mesure de courant sont nombreux. Il peut s'agir notamment de l'évaluation de la consommation électrique dans des bâtiments qu'ils soient industriels ou domestiques, dans des moyens de transports terrestres, maritimes ou aériens. Un autre domaine est, par exemple, la fonction de protection par déclenchement de disjoncteurs des installations électriques dans les mêmes environnements. On peut également s'en servir pour assurer la protection des moteurs électriques dont les enroulements en cuivre coûteux ne doivent pas être parcourus par de trop forts courants électriques qui détériorent les isolants et causent des courts-circuits. Encore d'autres utilisations possibles sont, par exemple, la détection et le positionnement de câbles électriques enterrés ou la mesure de courants induits dans le contrôle non destructif ou la recherche de matériaux.

Il est bien entendu que dans d'autres applications la mesure du gradient d'une composante d'un champ magnétique peut être utilisée telle quelle sans à avoir recours à une circulation de courant.

## ÉTAT DE LA TECHNIQUE ANTÉRIEURE

La mesure du gradient d'une composante d'un champ magnétique peut se faire à l'aide de deux capteurs, par exemple des paires de bobines de détection comme dans le brevet [1] dont les références complètes se trouvent en fin de description, chacun placés en une position, les deux capteurs étant très proches. Chacun des capteurs mesure la composante du champ magnétique et la différence entre les deux mesures permet de remonter au gradient du champ magnétique. Mais la présence du circuit magnétique de l'un des capteurs peut perturber la mesure de l'autre capteur et vice versa. De plus la précision de la mesure de gradient est limitée par la précision des deux capteurs, par la précision de la connaissance de leurs positions et par la reproductibilité des propriétés de chacun des capteurs pris individuellement.

Dans d'autres dispositifs, on n'utilise qu'un seul capteur de champ magnétique comme dans le document [2]. Ce capteur est déplacé selon la direction du gradient. La variation du signal délivré par le capteur en fonction de sa position permet de remonter au gradient du champ magnétique. Ce document élimine les inconvénients liés à la présence des deux capteurs mais une mesure précise de la position est toujours requise, ce qui limite la sensibilité de la mesure du gradient.

Dans le document [3], il n'est utilisé qu'un seul capteur et ce capteur est sensible directement au gradient d'un champ magnétique. L'avantage d'utiliser un capteur de gradient d'une composante d'un champ magnétique est que celui-ci est moins sensible à des gradients de champs magnétiques parasites générés par exemple par des courants circulant dans des conducteurs filaires parasites éloignés. En effet en un point donné, le champ magnétique créé par un conducteur filaire est proportionnel à $1/r$, $r$ représentant la distance entre le point donné et le centre du conducteur filaire. Le gradient du champ magnétique est lui proportionnel à $1/r^2$.

Dans ce document, le capteur est réalisé par une poutre conductrice de l'électricité encastrée à ses deux extrémités. On l'alimente en courant alternatif à une fréquence correspondant à un mode de résonance paire mécanique de la poutre. Un gradient de champ magnétique entraîne une déformation de la poutre et la détection de cette déformation permet de remonter à la mesure du gradient du champ magnétique. L'inconvénient de ce capteur est qu'il consomme de l'électricité de manière relativement importante. De plus la précision de la mesure est conditionnée par l'homogénéité des propriétés mécaniques et électriques de la poutre sur toute sa longueur.

Dans le document [4], est décrite, en tant que capteur de gradient d'une composante d'un champ magnétique, une fibre optique recouverte d'un matériau ferromagnétique dur tel que le samarium-cobalt, le néodyme-fer-bore ou le baryum-fer et dont les deux extrémités sont encastrées. Un gradient de champ magnétique génère une force qui déforme la fibre optique. La déformation est détectée par interférométrie dans la fibre optique. L'utilisation de la fibre optique ne permet pas de réaliser un capteur à l'échelle micrométrique par des technologies collectives de la microélectronique ou de la microélectromécanique.

Dans le document [5], il est décrit un capteur de gradient d'une composante d'un champ magnétique comportant une poutre en matériau piézoélectrique encastrée à une extrémité et dont l'autre extrémité est libre et supporte un aimant permanent. La force créée par le gradient de la composante du champ magnétique sur l'aimant permanent entraîne une contrainte dans le matériau piézoélectrique de la poutre et donc l'apparition d'une tension électrique qui peut être mesurée.

Un inconvénient de la structure décrite dans le document [5] et de celle décrite dans le document [4] est que, lorsque l'aimant est soumis à un champ magnétique qui n'est pas colinéaire à sa direction d'aimantation, il est soumis à un couple qui peut générer une déformation parasite sur la poutre ou sur la fibre optique. Cela peut nuire à l'exactitude de la mesure ou tout du moins restreindre de manière sensible les conditions d'utilisation du détecteur.

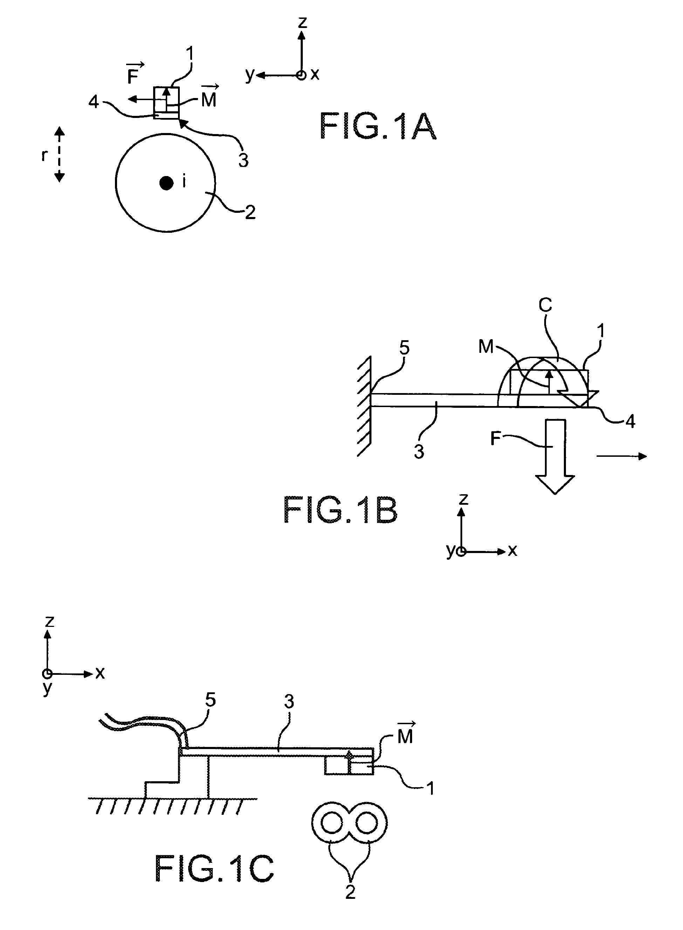

On va rentrer un peu plus dans le détail des principes physiques utilisés dans le document [5] en se référant aux figures 1A et 1B sur lesquelles un repère orthonormé x,y,z est indiqué.

Lorsqu'un aimant permanent 1 est soumis à un gradient d'une composante d'un champ magnétique, une force F s'applique sur lui et cette force F est proportionnelle au gradient de champ magnétique. Dans la suite de la description, pour simplifier on parlera à plusieurs reprises de champ magnétique et de gradient de champ magnétique au lieu de gradient d'une composante du champ magnétique.

La force volumique générée par un champ magnétique dans lequel se trouve l'aimant 1 s'exprime

$$\text{par} : \delta \vec{F} = -(\vec{M} \bullet \vec{\nabla}) \vec{B} \qquad (1)$$

Ainsi si le champ magnétique B est orienté selon l'axe y, et si le gradient de champ magnétique est orienté selon l'axe z, la force F qui s'applique sur l'aimant permanent 1 est orientée selon l'axe y si l'aimant permanent 1 à une direction d'aimantation M orientée selon l'axe z. On suppose que le champ magnétique B est créé par un courant i circulant dans un conducteur électrique filaire 2 orienté selon l'axe x. Par rapport à une section droite du conducteur filaire 2, le champ magnétique B est tangentiel et le gradient de champ magnétique est radial. L'aimant 1 est placé, par exemple, à une extrémité libre 4 d'une poutre 3 dont l'autre extrémité 5 est encastrée.

Un champ magnétique perpendiculaire à un gradient de champ magnétique, comme c'est le cas pour le champ créé par un conducteur filaire va créer, en plus d'une force, un couple C sur l'aimant permanent 1 qui va déformer la poutre 3 en torsion selon z et y. Ce couple va perturber l'effet de la mesure de la force F créée par le gradient de champ magnétique engendré par la circulation du courant i. Cette déformation va être sensiblement identique à celle générée par le gradient de champ magnétique qui est aussi selon z.

Un calcul analytique montre que la déflexion de la poutre Zgrad due au gradient de champ magnétique et que la déflexion de la poutre Zchamp due au couple généré par le champ magnétique orthogonal à l'aimantation de l'aimant permanent ont sensiblement le même ordre de grandeur.

$$zgrad = 4 \frac{Vaimant\, M(\partial Bx / \partial r)}{EWt^3} L^3 \qquad (2)$$

$$zchamp = 6 \frac{Vaimant\, MBx}{EWt^3} L^2 \qquad (3)$$

$$\frac{zgrad}{zchamp} = \frac{2L}{3r} \qquad (4)$$

avec

- Vaimant volume de l'aimant permanent
- M son aimantation
- Bx la composante du champ magnétique selon l'axe x
- r la distance entre le centre du conducteur filaire, supposé cylindrique, et l'aimant
- E le module d'Young du matériau de la poutre
- W la largeur de la poutre
- t l'épaisseur de la poutre
- L la longueur de la poutre

L'équation (4) montre que pour différencier au maximum la déflexion de la poutre Zgrad de la déflexion de la poutre Zchamp, on a intérêt à minimiser r qui se trouve au dénominateur et à maximiser L qui se trouve au numérateur de la fraction. Cette grandeur r est conditionnée par le rayon du conducteur filaire et par l'épaisseur de la poutre qui correspond à un substrat sur lequel est placé l'aimant permanent dans le cas d'une réalisation en technologie de la microélectronique ou microélectromécanique. Le fait de maximiser la longueur de la poutre est contraire aux objectifs de miniaturisation du capteur.

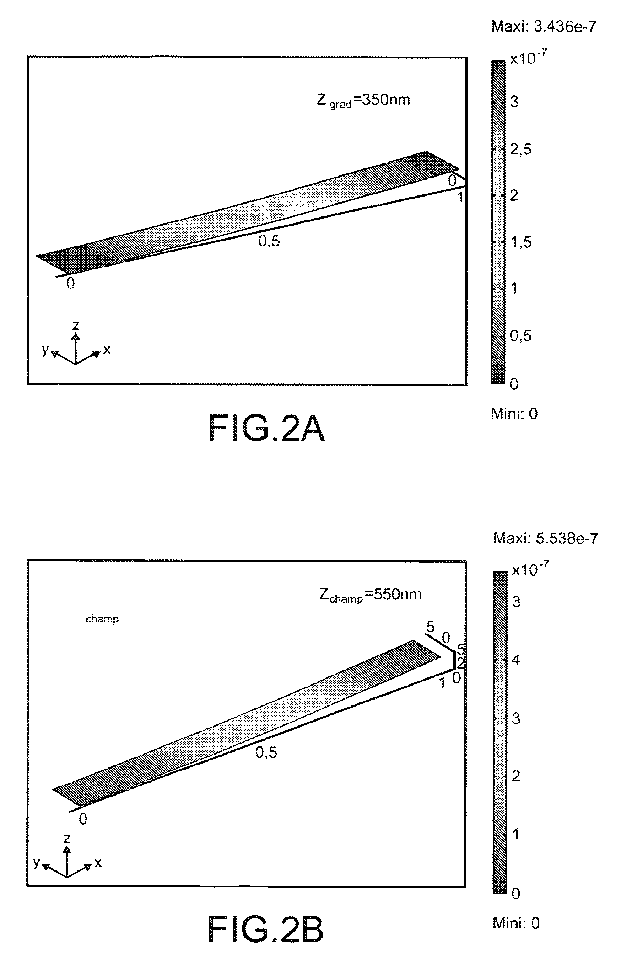

On s'aperçoit qu'il n'est pas possible de distinguer ces deux déformations l'une de l'autre. Les figures 2A et 2B illustrent ces propos. La figure 2A illustre la simulation numérique de la déformation d'une poutre en silicium avec :

- L= 1000 micromètres,
- W = 100 micromètres et
- t= 1 micromètre.

La poutre est équipée à une extrémité libre d'un aimant permanent parallélépipédique de 100x100x1 micromètres au cube, sous l'effet d'un gradient de champ magnétique équivalent à celui généré par un courant de 1A circulant dans un conducteur filaire se trouvant à 1 millimètre de l'aimant permanent.

La déflexion Zgrad de l'extrémité de la poutre vaut 350 nm sur la figure 2A.

Sur la figure 2B, on a représenté pour un même ensemble poutre, aimant permanent et conducteur filaire, la déflexion de la poutre sous l'effet d'un champ magnétique équivalent à celui généré par la circulation du courant. La déflexion Zchamp de l'extrémité de la poutre vaut 550 nm.

Pour que la direction d'aimantation de l'aimant soit colinéaire au champ magnétique et ainsi éviter la création d'un couple sur l'aimant, le document [5] propose de disposer deux conducteurs filaires 2' parallèles et proches l'un de l'autre à équidistance de l'aimant permanent 1. On se réfère à la figure 1C. Les deux conducteurs filaires 2' sont parcourus par un même courant électrique, en sens inverse. Ainsi maintenant, le champ magnétique est dirigé selon z comme le gradient de champ magnétique et comme l'aimantation M de l'aimant permanent 1. Les inconvénients de ce dispositif sont, d'une part qu'il est difficile de positionner l'aimant permanent 1 pour qu'il soit parfaitement équidistant des deux conducteurs filaires 2' et d'autre part qu'exactement un même courant doit circuler dans les deux conducteurs filaires 2'. En cas de différence, la mesure du gradient de champ magnétique ne sera pas fiable.

Les documents US 2003/0020472 et WO 2005/062064 montrent respectivement un capteur de champ magnétique et un capteur de gradient de champ magnétique fonctionnant grâce à la force de Lorentz et dépourvus d'aimant permanent.

Le document WO 01/67122 décrit un capteur de gradient de champ magnétique utilisant un oscillateur mécanique sur lequel est placé un élément en matériau magnétique doux.

## EXPOSÉ DE L'INVENTION

La présente invention a justement comme but de proposer un capteur du gradient d'une composante d'un champ magnétique pourvu d'un aimant permanent qui ne présente pas les inconvénients mentionnés ci dessus.

Plus particulièrement, la présente invention a pour but de proposer un tel capteur qui permette de distinguer la contribution de la force générée par le gradient de celle du couple généré par le champ magnétique lorsqu'il n'est pas colinéaire à la direction de l'aimantation de l'aimant.

Un autre but de l'invention est de proposer un tel capteur dans lequel la précision de positionnement du capteur influe peu sur la précision de la mesure.

Encore un autre but de l'invention est de proposer un tel capteur qui consomme peu d'énergie en fonctionnement.

Pour y parvenir, la présente invention propose de placer l'aimant sur une masse déformable apte à se déformer sous l'effet d'une force induite sur l'aimant par le gradient, cette force ayant pour effet de déplacer l'aimant dans une direction sensiblement colinéaire à la composante du champ magnétique pour laquelle le capteur a à acquérir le gradient, la masse déformable étant ancrée en au moins deux points sensiblement opposés par rapport à la masse déformable à un dispositif support fixe, l'aimant ayant une direction d'aimantation qui est sensiblement colinéaire à la direction du gradient de la composante du champ magnétique que le capteur a à acquérir.

Plus précisément, la présente invention est un capteur de gradient d'une composante d'un champ magnétique comportant au moins un capteur élémentaire comprenant une masse déformable équipée d'un aimant permanent ayant une direction d'aimantation sensiblement colinéaire à la direction du gradient de la composante du champ magnétique à acquérir par le capteur. La masse déformable est apte à se déformer sous l'effet d'une force induite sur l'aimant par le gradient, cette force ayant pour effet de le déplacer, en entraînant la masse déformable, dans une direction sensiblement colinéaire à la composante du champ magnétique pour laquelle le capteur a à acquérir le gradient. La masse déformable est ancrée à un dispositif de support fixe en au moins deux points d'ancrage sensiblement opposés par rapport à la masse. Le capteur élémentaire comporte en outre des moyens de mesure d'au moins une grandeur électrique traduisant une déformation ou une contrainte de la masse déformable engendrée par le gradient.

Lorsque la masse déformable s'étend au repos sensiblement dans un plan, la direction d'aimantation de l'aimant permanent est de préférence sensiblement normale au plan.

Un point d'ancrage de la masse déformable peut être relié directement au dispositif de support ou indirectement par l'intermédiaire d'un bras élastique.

On peut suspendre la masse déformable par rapport au dispositif de support à l'aide d'au moins deux bras élastiques dirigés sensiblement dans le plan de la masse déformable.

Les bras élastiques peuvent comporter au moins un tronçon principal. Deux bras élastiques formant une paire possèdent des tronçons principaux situés dans le prolongement l'un de l'autre.

Le déplacement de l'aimant se fait de préférence selon un axe du plan, sensiblement normal à l'axe des tronçons principaux.

Lorsque le capteur élémentaire comporte deux paires de bras élastiques, les points d'ancrage de la masse déformable auxquels sont reliés deux bras élastiques n'appartenant pas à la même paire sont les plus éloignés possible.

Lorsque le capteur élémentaire comporte deux paires de bras élastiques, les points d'ancrage de la masse déformable auxquels sont reliés les bras élastiques des deux paires sont placés symétriquement par rapport à un axe de symétrie de la masse déformable.

Les bras élastiques ont une épaisseur et une largeur telle que leur épaisseur soit supérieure à leur largeur pour être plus rigides selon des directions sensiblement orthogonales à la direction de la force induite sur l'aimant par le gradient.

Chaque bras élastique peut comporter un tronçon additionnel relié au tronçon principal et agencé de manière que deux points d'ancrage voisins de la masse déformable auxquels sont reliés deux bras élastiques de paires différentes sont moins éloignés que des points d'ancrage aux quels sont reliés ces bras élastiques sur le dispositif de support.

Lorsque le capteur élémentaire comporte une seule paire de bras élastiques, l'axe des tronçons principaux des bras élastiques est confondu avec un axe de symétrie de la masse déformable.

Les moyens de mesure d'une grandeur traduisant la contrainte ou la déformation peuvent être différentiels. Ceci permet de faciliter encore davantage la distinction entre la déformation due à une force et celle due à un couple.

Les moyens de mesure différentielle peuvent être capacitifs ou comporter au moins une paire de jauges de contrainte.

Le capteur peut comporter en outre des moyens d'excitation de la masse déformable pour la faire vibrer, ces moyens d'excitation étant notamment électrostatiques, piézoélectriques ou magnétiques.

La masse déformable peut présenter une déformation qui est non linéaire en fonction de la force qui s'applique sur l'aimant due au gradient.

Pour distinguer une contribution due à un gradient de champ magnétique de celle due à une accélération et éventuellement mesurer le gradient et l'accélération simultanément, le capteur peut comporter deux capteurs élémentaires dans lesquels les aimants des masses déformables ont des directions d'aimantation opposées.

La masse déformable peut être ancrée au dispositif de support au niveau d'une ou plusieurs zones de sa périphérie ou sur toute sa périphérie.

La présente invention concerne également un procédé de fabrication d'un capteur de gradient d'une composante d'un champ magnétique, comportant les étapes consistant à :

fournir un substrat de base comportant une couche sacrificielle enterrée sous une couche superficielle en matériau semi-conducteur,
creuser au moins un caisson dans la couche superficielle sans atteindre la couche sacrificielle, ce caisson étant destiné à loger un aimant permanent devant être incorporé dans une masse déformable délimitée ultérieurement dans la couche superficielle,
remplir le caisson de matériau magnétique et aimanter le matériau magnétique dans le caisson
former des contacts métalliques sur la couche superficielle destinés à des moyens de mesure d'au moins une grandeur électrique traduisant une déformation ou une contrainte de la masse déformable engendrée par le gradient, ce gradient étant sensiblement colinéaire à la direction de l'aimantation de l'aimant,
graver dans la couche superficielle une ou plusieurs tranchées mettant à nu la couche sacrificielle de manière à délimiter le contour de la masse déformable et d'au moins deux points d'ancrage de la masse déformable à un dispositif de support fixe, ces deux points étant opposés par rapport à la masse déformable,
éliminer la couche sacrificielle sous la masse déformable pour la libérer de manière à ce que les points d'ancrage restent reliés au dispositif de support.

On peut tapisser le caisson avec une couche barrière avant le remplissage pour éviter une diffusion.

On peut revêtir superficiellement l'aimant avec une couche de passivation avant la formation des contacts électriques.

On peut effectuer une étape de recuit avant l'aimantation pour cristalliser le matériau magnétique.

## BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :

la figure 1A (déjà décrite) montre la force s'appliquant sur un aimant placé en bout d'une poutre lorsqu'il se trouve à côté d'un conducteur filaire parcouru par un courant électrique ;
la figure 1B (déjà décrite) montre le couple induit par un champ magnétique auquel est soumis un aimant placé en bout d'une poutre et la déformation de cette poutre résultant de ce couple ;
la figure 1C (déjà décrite) montre le capteur de gradient d'une composante d'un champ magnétique illustré dans le document [4] ;
les figures 2A, 2B (déjà décrites) montrent la déformation d'une poutre portant en bout un aimant sous l'effet respectivement d'un gradient de champ magnétique et d'un champ magnétique ;
la figure 3 montre un exemple de capteur de gradient d'une composante d'un champ magnétique selon l'invention ne possédant qu'une paire de bras élastiques ;
les figures 4A et 5 à 7 montrent, en vue de dessus, plusieurs exemples de capteurs de gradient d'une composante d'un champ magnétique selon l'invention à deux paires de bras élastiques, les figures 4B et 4C montrant d'autres exemples de masse mobile de capteurs de gradient d'une composante d'un champ magnétique selon l'invention ;
les figures 8A, 8B, 8C montrent respectivement la déformation d'un capteur de la figure 4, lorsqu'il est soumis à un gradient de champ magnétique d'axe z, à un champ magnétique d'axe y et à un champ magnétique d'axe x ;
les figures 9A, 9B, montrent respectivement la déformation d'un capteur dont la masse déformable est plus large que celle montrée aux figures 8, lorsqu'il est soumis à un gradient de champ magnétique d'axe z et à un champ magnétique d'axe x ;
la figure 10 montre la déformation d'un capteur similaire à celui de la figure 7, lorsqu'il est soumis à un champ magnétique d'axe x ;
les figures 11A, 11B, 11C montrent respectivement la déformation d'un capteur de la figure 4 mais dont la masse déformable et les bras élastiques sont épaissis, lorsqu'il est soumis à un gradient de champ magnétique d'axe z, à un champ magnétique d'axe y et à un champ magnétique d'axe x ;
la figure 12 montre, à la manière de la figure 3, un capteur de gradient d'une composante d'un champ magnétique apte à mesurer également une accélération ;
les figures 13A à 13G montrent en coupe des étapes de réalisation d'un capteur selon l'invention ;
la figure 14 montre en vue de dessus un capteur réalisé par le procédé de l'invention ;
les figures 15A, 15B, 15C représentent d'autres variantes de capteurs selon l'invention dans lesquels les moyens d'excitation sont respectivement électrostatiques, piézoélectriques et magnétiques.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

## EXPOSÉ DÉTAILLÉ DE MODES DE RÉALISATION PARTICULIERS

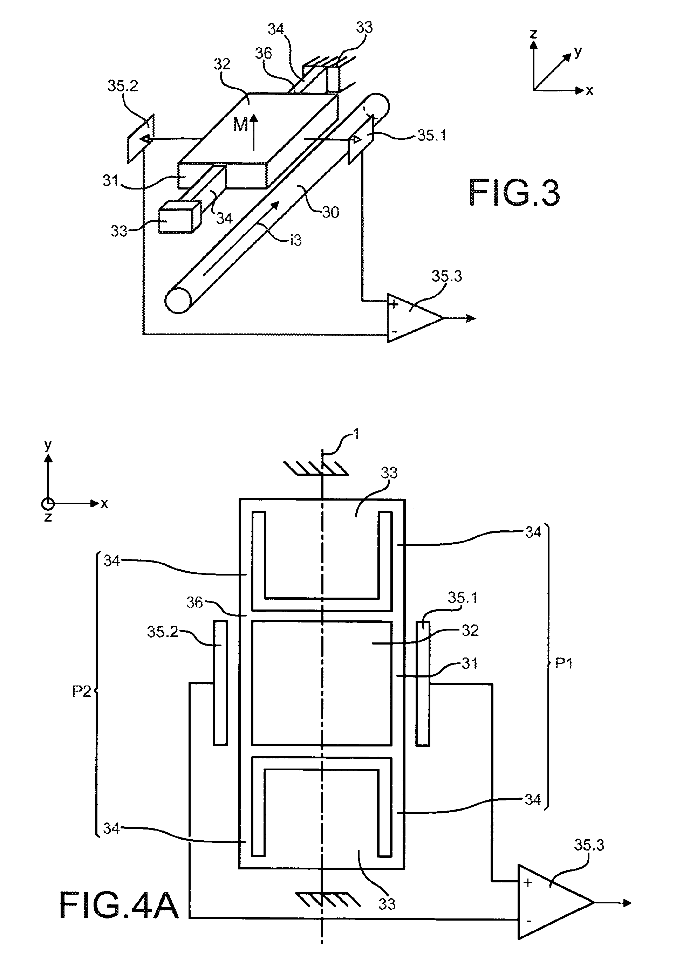

On va maintenant se référer à la figure 3 qui montre un capteur d'un gradient d'une composante d'un champ magnétique selon l'invention. On suppose que le champ magnétique est généré par un courant i3 circulant dans un conducteur électrique filaire 30 dirigé selon l'axe y du repère orthonormé. Le capteur du gradient de la composante du champ magnétique comporte au moins capteur élémentaire CE1 comprenant une masse déformable 31 équipée d'un aimant permanent 32. La masse déformable 31 s'étend au repos dans le plan x,y. La masse déformable 31 peut prendre la forme d'une membrane, ce qui signifie que son épaisseur est très inférieure à ses deux autres dimensions. La masse déformable 31 est apte à se déformer sous l'effet d'une force induite par le gradient de champ magnétique, cette force s'appliquant sur l'aimant 32. Cette force a pour effet de déplacer l'aimant 32 et ce dernier entraîne avec lui localement la masse déformable 31 d'où sa déformation. Le déplacement se fait dans une direction sensiblement colinéaire à la composante du champ magnétique pour laquelle le capteur doit acquérir le gradient. L'état de déformation de la masse déformable 31 sera différent selon l'intensité du gradient de champ magnétique qui s'applique.

L'aimantation M de l'aimant 32 est dirigée selon l'axe z. Plus précisément, l'aimant 32 a une direction d'aimantation qui est sensiblement colinéaire à la direction du gradient de la composante du champ magnétique que le capteur doit acquérir.

La masse déformable 31 est ancrée en au moins deux points 36 sensiblement opposés par rapport à la masse déformable, à un dispositif de support fixe 33. Le dispositif de support 33 est dit fixe car il reste immobile par rapport à la masse déformable 31 lorsque cette dernière effectue un déplacement entraînée par l'aimant 32.

Dans l'exemple illustré sur la figure 3, la masse déformable 31 est suspendue au dispositif de support 33 par l'intermédiaire d'une paire de bras élastiques 34. Par bras élastiques, on entend des bras qui sont aptes à se déformer sous l'effet d'une sollicitation et qui reprennent leur forme initiale après suppression de la sollicitation. On pourrait utiliser plusieurs paires de bras élastiques ou même un nombre impair de bras élastiques supérieur strictement à un. Les bras élastiques 34 sont fixés d'un côté au dispositif de support 33 et de l'autre à un bord de la masse déformable 31. Les bras élastiques s'étendent au repos dans le plan x,y. Chaque bras élastique 34 d'une paire comporte un tronçon dit principal 34' s'étendant transversalement entre la masse déformable 31 et le dispositif de support 33. Les tronçons principaux 34' des bras élastiques 34 d'une paire sont dans le prolongement l'un de l'autre. Les tronçons principaux 34' s'étendent selon l'axe y. Dans l'exemple de la figure 3, les bras élastiques et les tronçons principaux ne font qu'un.

Les bras élastiques 34 sont représentés rectilignes et orientés selon l'axe y tout comme le conducteur filaire 30. D'autres configurations sont possibles. Si le gradient de champ magnétique n'est pas généré par un courant circulant dans un conducteur électrique filaire, on positionne le capteur selon l'invention de manière à ce que le gradient de champ magnétique soit colinéaire avec la direction d'aimantation M de l'aimant permanent 32 et que la direction du champ magnétique soit colinéaire à l'axe x de déplacement de l'aimant 32.

Lorsqu'il n'y a qu'une seule paire de bras élastiques 34, il est préférable que l'axe de leurs tronçons principaux 34' passe par le centre de gravité de la masse déformable 31. L'axe y des tronçons principaux 34' est confondu avec un axe de symétrie y1 de la masse déformable 31. Cette symétrie est en effet requise pour bien distinguer la contribution due au gradient de champ de celle due à un champ magnétique.

Le capteur élémentaire comporte de plus des moyens de mesure 35 d'une grandeur électrique traduisant une contrainte ou une déformation de la masse déformable 31 engendrée par le gradient. La déformation résulte d'un déplacement de l'aimant 31, ce déplacement est dirigé selon l'axe x, c'est-à-dire transversal à l'axe des tronçons principaux 34'. Cette déformation se produit lorsque la masse déformable 31 est soumise à un gradient de champ magnétique selon z, le champ magnétique étant orienté selon l'axe x. Dans le mode de réalisation de la figure 3, le gradient est orienté selon l'axe z alors que le champ magnétique qui le génère est orienté selon l'axe x. Dans l'exemple décrit à la figure 3, on suppose que les moyens de mesure 35 effectuent une mesure différentielle et qu'ils sont de type capacitifs avec une paire d'électrodes 35.1, 35.2 en vis-à-vis de part et d'autre de l'aimant permanent 30. Ils mesurent une variation de capacité. L'une des électrodes 35.1 est reliée à une entrée d'un amplificateur différentiel 35.3 et l'autre électrode 35.2 à l'autre entrée. Chacune de ces électrodes 35.1, 35.2 mesure un signal en tension et l'amplificateur différentiel délivre un signal représentatif d'une variation de capacité vis-à-vis de l'aimant permanent 32. Le dispositif de support 33 est porté à une masse électrique. Cette variation de capacité traduit un déplacement latéral de la masse déformable 31 et donc une déformation de celle-ci. Les électrodes 35.1, 35.2 de la paire ont une face sensiblement transversale à la direction du déplacement mesuré.

Le déplacement créé par le gradient de champ magnétique fait varier le signal délivré par chacune des électrodes 35.1, 35.2 dans des sens opposés, alors que le déplacement engendré par un couple crée par le champ magnétique selon x ou selon y, combiné à l'aimantation M de l'aimant permanent 32 fait varier le signal délivré par chacune des électrodes 35.1, 35.2 dans le même sens. Avec une telle mesure différentielle, lors de la mesure du déplacement latéral, on peut éliminer la contribution due au champ magnétique dans la mesure où il est non colinéaire à la direction d'aimantation de l'aimant permanent 32 et engendre un couple. On ne conserve que la contribution due au gradient de champ magnétique.

La figure 4A montre en vue de dessus d'un capteur de gradient d'une composante d'un champ magnétique selon l'invention. Une différence avec celui illustré à la figure 3, se situe au niveau des bras élastiques 34 qui maintenant sont répartis en deux paires P1, P2. Les points d'ancrage 36 de la masse déformable 31 auxquels sont reliés deux bras élastiques 34 n'appartenant à la même paire P1 ou P2 de bras élastiques sont les plus éloignés possible. Dans l'exemple, ces points d'ancrage 36 sont au niveau de coins de la masse déformable 31 qui prend la forme d'une membrane sensiblement rectangulaire. Les deux paires P1, P2 de bras sont disposées de manière sensiblement symétrique par rapport à un axe de symétrie y1 autour duquel est construite la masse déformable 31. Cet axe de symétrie y1 est orienté selon l'axe y. Un tel ancrage avec deux paires P1, P2 de bras élastiques limite encore plus l'impact du couple généré par la combinaison du champ magnétique orienté selon l'axe x ou y et de l'aimantation de l'aimant orientée selon l'axe z. Les deux modes de réalisation des figures 3 et 4A fonctionnent sans moyens de mise en vibration forcée de la masse déformable 31. Le déplacement de l'aimant et donc de la masse déformable 31 n'est dû qu'au gradient de champ magnétique et dans une moindre mesure au champ magnétique lui-même puisque avec les deux paires P1, P2 de bras élastiques, le capteur est peu sensible au couple généré par la combinaison du champ magnétique et de l'aimantation de l'aimant permanent.

Bien sûr le capteur peut fonctionner avec un nombre impair de bras élastiques, ce nombre étant supérieur à un. On peut par exemple envisager d'avoir trois bras élastiques répartis sensiblement de façon équidistante ou non autour de la masse déformable 31.

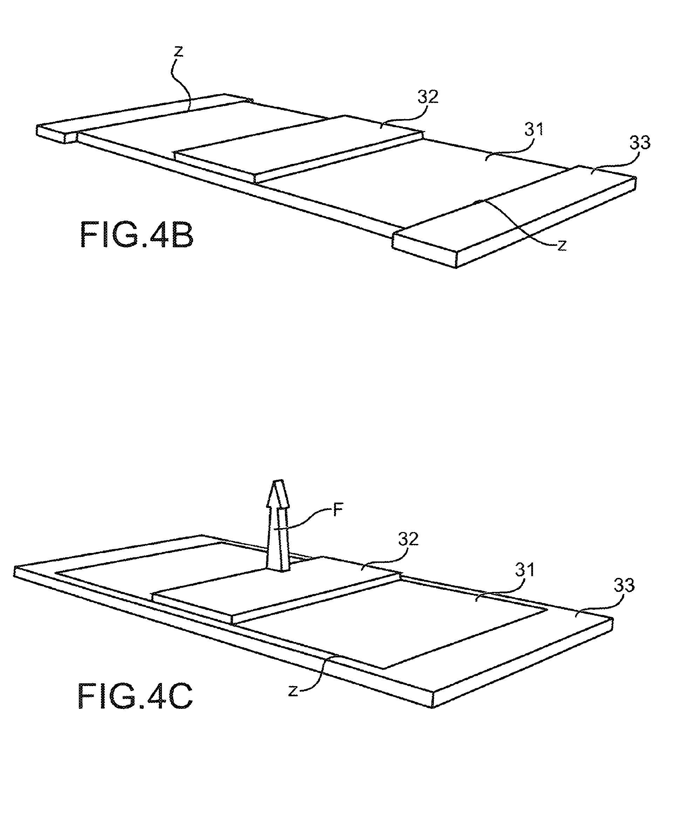

Il est possible de se passer de bras élastiques, la masse déformable 31 peut alors être directement ancrée au dispositif de support 33. Sur les figures 4B, 4C, la masse déformable 31 est ancrée en une ou plusieurs zones Z dite d'encastrement de sa périphérie au dispositif de support 33, chaque zone Z correspond à une pluralité de points d'ancrage successifs. Sur la figure 4B, la masse déformable 31 prend la forme d'une poutre sensiblement rectangulaire et les zones correspondent à ses deux largeurs, elles sont ancrées au dispositif de support fixe 33.

En variante illustrée sur la figure 4C, l'ancrage au dispositif de support fixe 33 se fait sur la zone Z de la périphérie, elle correspond à toute la périphérie de la masse déformable 31.

Dans l'exemple décrit à la figure 4A, les moyens de mesure de la grandeur électrique traduisant la déformation de la masse déformable sont de même nature que ceux décrits à la figure 3. La détection est différentielle, elle se fait également de manière capacitive, seul le gradient de champ magnétique déformant et donc déplaçant la masse déformable 31.

Il est possible de prévoir des moyens d'excitation de la masse déformable 31 pour la faire vibrer. Dans ce cas, on choisit une masse déformable dont la déformation est non linéaire en fonction de la force qui s'applique sur l'aimant due au gradient de champ magnétique. La masse déformable 31 vibrera de manière différente selon l'intensité de la force qui s'applique sur elle via l'aimant en présence d'un gradient de champ magnétique. La mesure du gradient de champ magnétique peut alors se faire en tirant partie de la réponse vibratoire de la masse déformable 31. Plusieurs techniques peuvent être utilisées pour obtenir le gradient. L'excitation et la mesure de la grandeur électrique représentative de la déformation ou de la contrainte peuvent être obtenues de différentes manières.

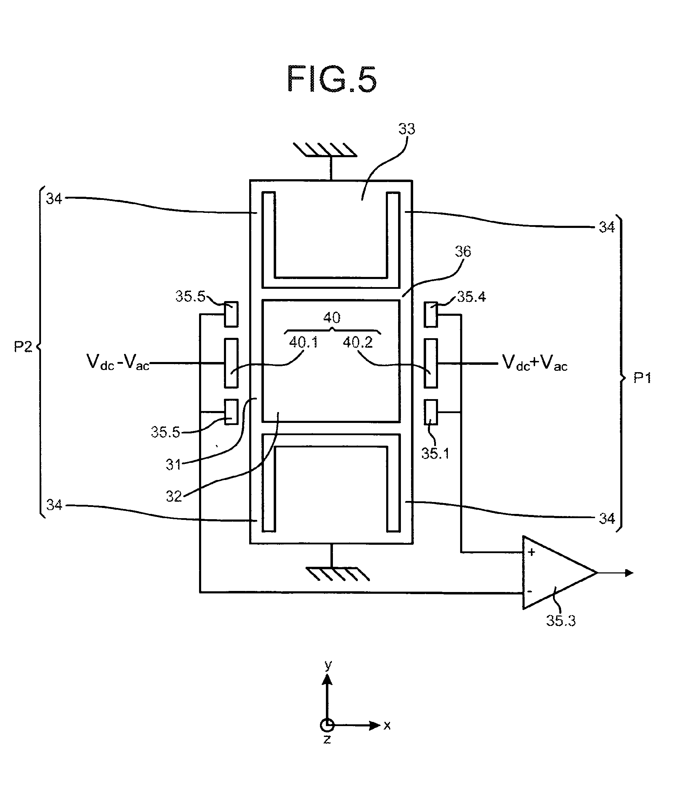

Sur la figure 5, les moyens d'excitation 40 de la masse déformable 31 sont électrostatiques et sont couplés à des moyens de mesure différentielle 35 d'une grandeur électrique traduisant une contrainte ou une déformation de la masse déformable 31 engendrée par le gradient. Les moyens d'excitation 40 comportent deux électrodes 40.1, 40.2 en vis-à-vis alimentées en opposition de phase. On leur applique une tension alternative Vac superposée à une tension continue Vdc. Les tensions alternatives sont en opposition de phase d'une électrode à l'autre. Les moyens de mesure différentielle 35 comportent maintenant deux paires d'électrodes (35.1, 35.2), (35.4, 35.5) en vis-à-vis, situées de part et d'autre d'une électrode des moyens d'excitation 40.

Une électrode 35.1, 35.4 d'une paire est reliée à une entrée de l'amplificateur différentiel 35.3 et l'autre électrode 35.2, 35.5 à l'autre.

Il est possible, en variante d'exploiter la fréquence de la vibration à laquelle la masse déformable est soumise.

Si l'on excite la masse déformable à une fréquence fondamentale f0, elle va se déformer en engendrant des harmoniques à la fréquence 2f0, 3f0, 4f0,..... L'amplitude des harmoniques dépend de la déformation de la masse déformable 31 due au gradient de champ magnétique ou de la contrainte prenant naissance dans la masse déformable. Une autre méthode peut utiliser la fréquence de résonance. La fréquence de résonance de la poutre peut varier en fonction du gradient de champ magnétique. La détermination du gradient peut être obtenue en recherchant cette fréquence de résonance ou en mesurant des variations d'amplitude autour de la résonance.

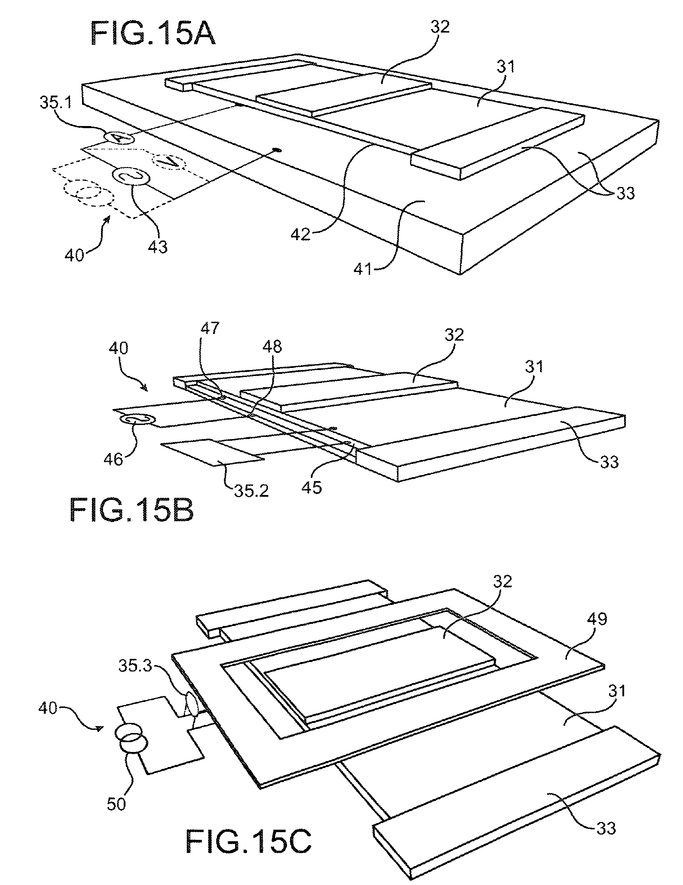

La figure 15A montre un capteur selon l'invention dans lequel les moyens d'excitation 40 sont électrostatiques. La masse déformable 31 prend la forme d'une membrane sensiblement rectangulaire qui est ancrée en deux zones d'extrémité 31.1 à un dispositif de support 33. Le terme membrane sera employé par la suite. Le dispositif de support 33 prend la forme d'un substrat. La masse déformable 31 est ainsi suspendue au-dessus du substrat 33. Les moyens d'excitation comportent deux plans conducteurs 42, 41 en vis-à-vis. L'un des plans 42 se trouve sur une face de la membrane 31 du côté du dispositif de support 33. L'autre plan conducteur 41 se trouve sur le dispositif de support 33 du côté de la membrane 31. En connectant ces deux plans conducteurs 41, 42 à une source de tension alternative 43 de préférence à fréquence commandable, une force d'attraction alternative prend naissance entre la membrane 31 et le dispositif de support 33. On choisit avantageusement la fréquence sensiblement égale à la fréquence de résonance fondamentale de la membrane 31. D'autres fréquences sont possibles mais nécessiteront plus d'énergie. Les moyens de mesure de la grandeur électrique traduisant la déformation ou la contrainte de la masse déformable 31 sont des moyens de mesure du courant 35.1 circulant entre l'un des plans conducteurs 42 et la source de tension 43. Il ne s'agit plus d'une mesure différentielle. Plus particulièrement en suivant l'évolution des harmoniques du courant, on peut remonter au gradient de champ magnétique. A l'inverse, il serait possible d'utiliser une source de courant au lieu d'une source de tension pour l'alimentation des plans conducteurs et de prévoir des moyens de mesure de tension aux bornes des plans conducteurs 41, 42. Cette variante est représentée, en pointillés, superposée au mode de réalisation avec la source de tension et les moyens de mesure du courant pour ne pas multiplier inutilement le nombre de figures. Mais elle ne pose aucun problème à un homme du métier.

Sur la figure 15B, la membrane se présente sous la même forme que sur la figure 15A et les moyens d'excitation 40 sont piézoélectriques. Ils comportent un élément piézoélectrique 45 en contact mécanique avec la membrane 31 et une source d'alimentation en tension 46 à fréquence commandable pour exciter l'élément piézoélectrique 45 via une paire d'électrodes 47, 48 situées de part et d'autre de l'élément 45 en matériau piézoélectrique. Cet élément 45 peut être une plaque de matériau piézoélectrique collée sous la membrane 31. L'élément piézoélectrique 45 crée, lorsqu'il est excité, des contraintes au sein de la membrane 31 et la fait vibrer. Au lieu d'utiliser un élément piézoélectrique de type plaque agencée comme on vient de le décrire, il est possible d'utiliser un plot en matériau piézoélectrique qui sert à ancrer la membrane au dispositif de support. L'excitation de ce plot permet de mettre en vibration la membrane. La fréquence est choisie pour correspondre à la fréquence de résonance fondamentale de la membrane 31. Les moyens de détection d'une grandeur électrique traduisant la contrainte due à la déformation dans la membrane 31 due au gradient de champ magnétique peuvent être réalisés par un analyseur d'impédance 35.2 permettant de mesurer et de suivre l'évolution de l'impédance de l'élément piézoélectrique. La mesure de l'impédance permet de remonter à la contrainte et donc à la déformation dans la membrane et donc au gradient de champ magnétique.

Sur la figure 15C, la membrane se présente sous la même forme que sur la figure 15A et les moyens d'excitation 40 sont magnétiques. Ils comportent une bobine 49 connectée à une source d'alimentation en courant alternatif 50 de préférence à fréquence commandable. On choisit avantageusement la fréquence sensiblement égale à la fréquence de résonance fondamentale de la membrane. La circulation du courant alternatif génère une force alternative qui s'applique sur l'aimant 32 et se superpose à celle générée par le gradient de champ magnétique. Les moyens de détection d'une grandeur électrique traduisant la déformation de la membrane incluent des moyens pour mesurer 35.3 la tension aux bornes de la bobine 49. La bobine 49 peut être positionnée sur la membrane du même côté que l'aimant 32 ou être de l'autre côté. En variante, elle peut se trouver à proximité de la membrane 31 sans prendre appui sur elle. Si la membrane 31 et l'aimant 32 sont formés par un MEMS (système système micro-électro-mécanique) la bobine peut être disposée à l'extérieur du MEMS, si on le souhaite. Elle est positionnée de manière à ce que le champ magnétique créé par la circulation du courant soit colinéaire à l'aimantation de l'aimant 32.

Dans les trois exemples décrits aux figures 15, il est possible d'inverser les courants et les tensions. L'excitation peut se faire en imposant le courant et la détection se fait avec la mesure d'une tension ou au contraire l'excitation peut se faire en imposant la tension et la détection avec la mesure d'un courant.

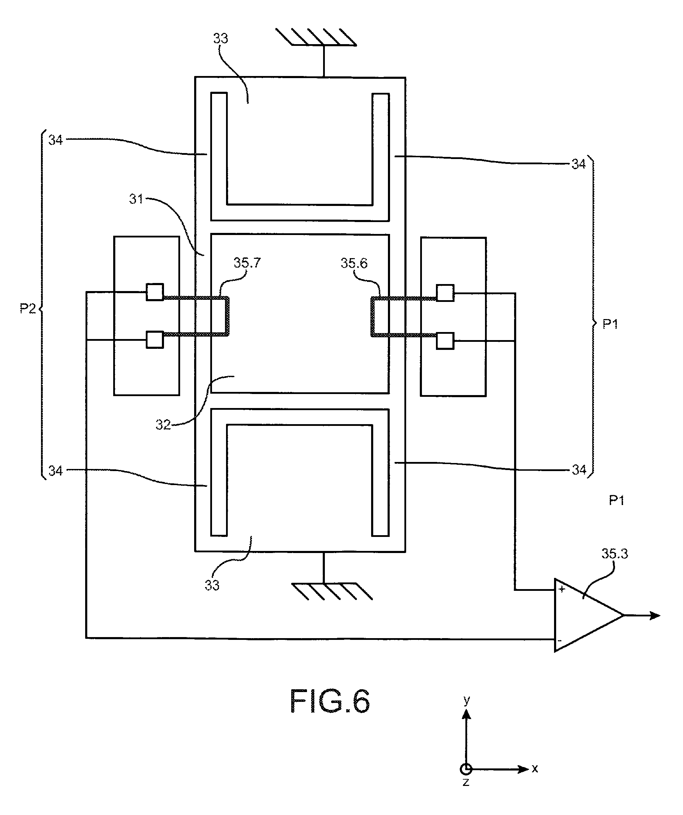

La figure 6 montre encore un mode de réalisation d'un capteur selon l'invention. Sur cette figure 6, les moyens de mesure 35 sont réalisés par une paire de jauges de contrainte 35.6, 35.7. Il s'agit de nouveau de moyens de mesure différentielle. Il peut s'agir de jauges piézo-résistives métalliques. Elles sont placées entre la masse déformable 31 et une zone ancrée. Les jauges de contrainte 35.6, 35.7 sont reliées en entrée d'un amplificateur différentiel 35.3. Les jauges de contrainte 35.6, 35.7 délivrent des signaux traduisant la contrainte générée par la force exercée sur l'aimant par le gradient de champ magnétique.

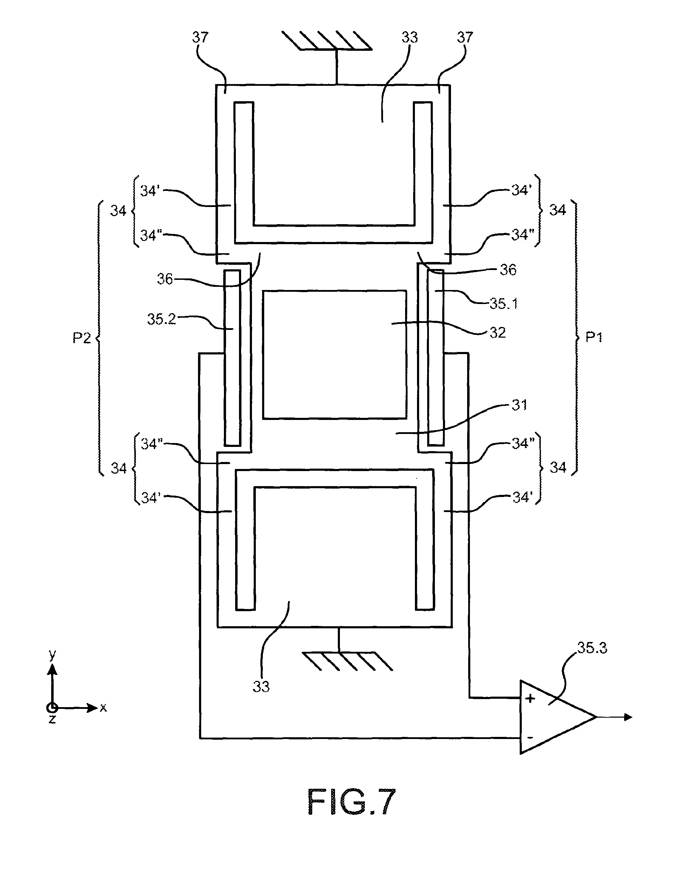

La figure 7 montre encore une variante d'un capteur selon l'invention. La différence par rapport aux modes de réalisation décrits précédemment se situe au niveau de la configuration des bras élastiques 34. Il y en a deux paires P1, P2 comme sur les figures 4 à 6, ils sont fixés aux coins de la structure résonante 31, mais maintenant, ils comportent chacun deux tronçons 34', 34" reliés entre eux, l'un des tronçons 34" est relié à la masse déformable 31 et l'autre à au dispositif de support 33. Le tronçon 34 " relié à la masse déformable 31 est dit additionnel, il est dirigé sensiblement selon l'axe x et le tronçon 34' relié au dispositif de support 33 est dirigé sensiblement selon l'axe y, il correspond au tronçon principal. Avec une telle configuration, on augmente le bras de levier entre la masse déformable 31 et le dispositif de support 33 sans à avoir à augmenter le volume de la masse déformable 31 et donc sa masse.

Deux points d'ancrage voisins 36 sur la masse déformable 31 appartenant à deux bras élastiques 34 de paires différentes P1, P2 sont moins éloignés que les points d'ancrage 37 de ces bras élastiques 34 sur le dispositif de support 33.

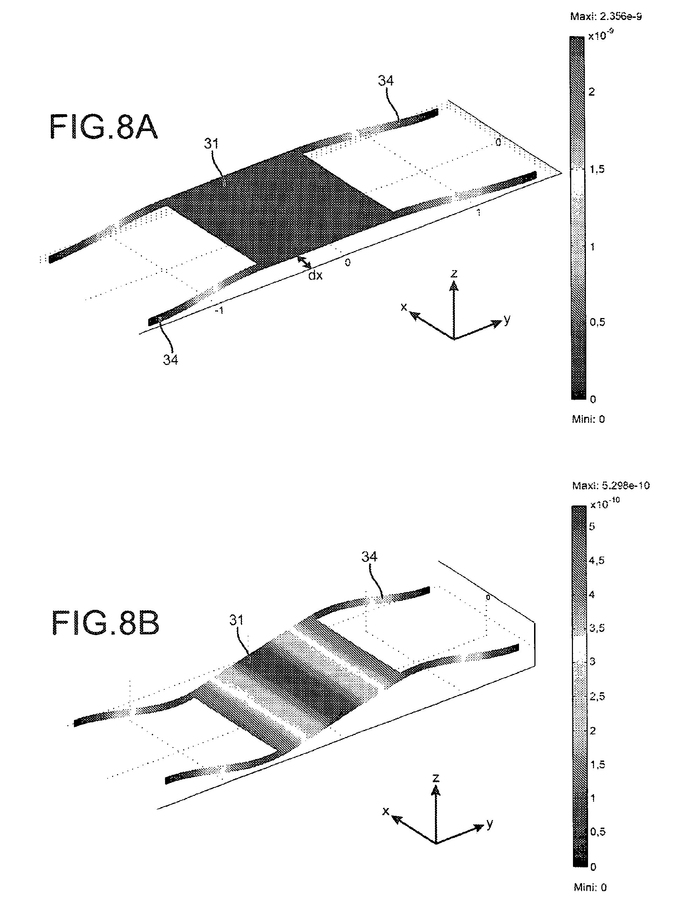

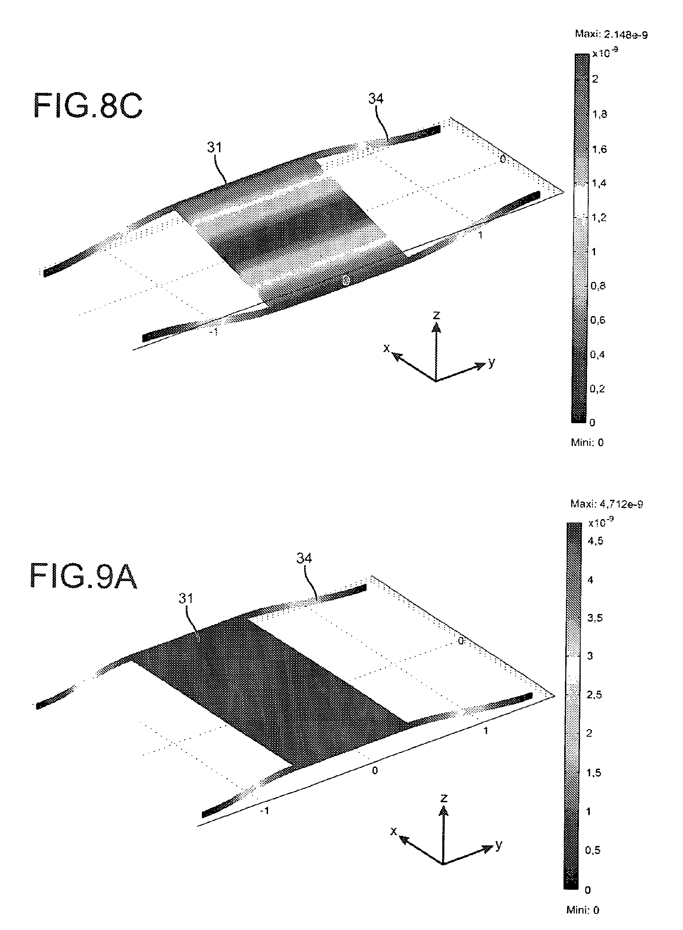

On va maintenant s'intéresser à des simulations faites avec un capteur de gradient d'une composante d'un champ magnétique selon l'invention en se référant aux figures 8A, 8B, 8C.

On a réalisé ces simulations avec un capteur de gradient d'une composante d'un champ magnétique comparable au point de vue structure à celui représenté à la figure 4A, ayant les caractéristiques suivantes :

• Dimensions de la masse déformable 31 : 100x100x5 micromètres au cube
• Dimensions des bras élastiques 34 qui sont sensiblement rectilignes : 100x1x5 micromètres au cube

L'aimant permanent que comporte la masse déformable 31 est aimanté verticalement (axe z). La masse déformable 31 s'étend sensiblement dans le plan x,y au repos. Sur la figure 8A, la masse déformable 31 est soumise à un gradient de champ magnétique dirigé selon l'axe z, c'est-à-dire dans la même direction que l'aimantation de l'aimant permanent 32. Les bras élastiques 34 répartis en deux paires s'étendent selon l'axe y au repos. On suppose que le gradient de champ magnétique est engendré par la circulation d'un courant de 1A dans un conducteur filaire sensiblement cylindrique placé à 1 mm de l'aimant permanent et dirigé dans le plan x,y. Le conducteur filaire n'est pas représenté ni l'aimant permanent.

) Le déplacement latéral dx de la masse déformable 31 se fait selon l'axe x, c'est-à-dire sensiblement perpendiculairement à l'axe y des bras élastiques 34 et à l'axe z de l'aimantation de l'aimant permanent 1. Ce déplacement est provoqué par un gradient de champ magnétique orienté selon l'axe z comme l'aimantation de l'aimant permanent 32. Ce déplacement latéral dx vaut 2,35 nm.

A cause de sa structure avec deux paires P1, P2 de bras élastiques 34 mis aux quatre coins de la masse déformable 31 sensiblement rectangulaire, le capteur est peu sensible au couple généré par la combinaison de l'aimantation de l'aimant permanent et du champ magnétique, dans la mesure où le champ magnétique n'est pas colinéaire à l'aimantation.

Sur les figures 8B et 8C, le champ magnétique est respectivement dirigé selon l'axe y et selon l'axe x.

On s'aperçoit que la flèche appelée zmax, c'est-à-dire le déplacement maximal selon l'axe z, de la masse déformable 31 engendrée par le couple provenant de la combinaison entre le champ magnétique et l'aimantation de l'aimant permanent 32 est très faible lorsque le champ magnétique est dirigé selon l'axe y. Cette flèche ne vaut que 0,5 nm sur la figure 8B.

Par contre, ce type de capteur présente une flèche plus importante, zmax = 2,2 nm, lorsque le champ magnétique est dirigé selon l'axe x comme illustré sur la figure 8C.

En effet la force F dirigée selon l'axe z est égale au rapport C/L où représente le couple qui s'applique sur la masse déformable 31 et L est le bras de levier entre le point d'application de la force F et la partie fixe, ce bras de levier dépendant de la longueur des bras élastiques 34.

La force F selon l'axe z et le couple C qui s'appliquent sur l'extrémité du bras élastique 34 sont proportionnels au volume de l'aimant. Si on augmente la dimension de la masse déformable 31 selon l'axe y, c'est-à-dire selon l'axe des bras élastiques 34, la force F sera d'autant plus grande car on augmente le bras de levier.

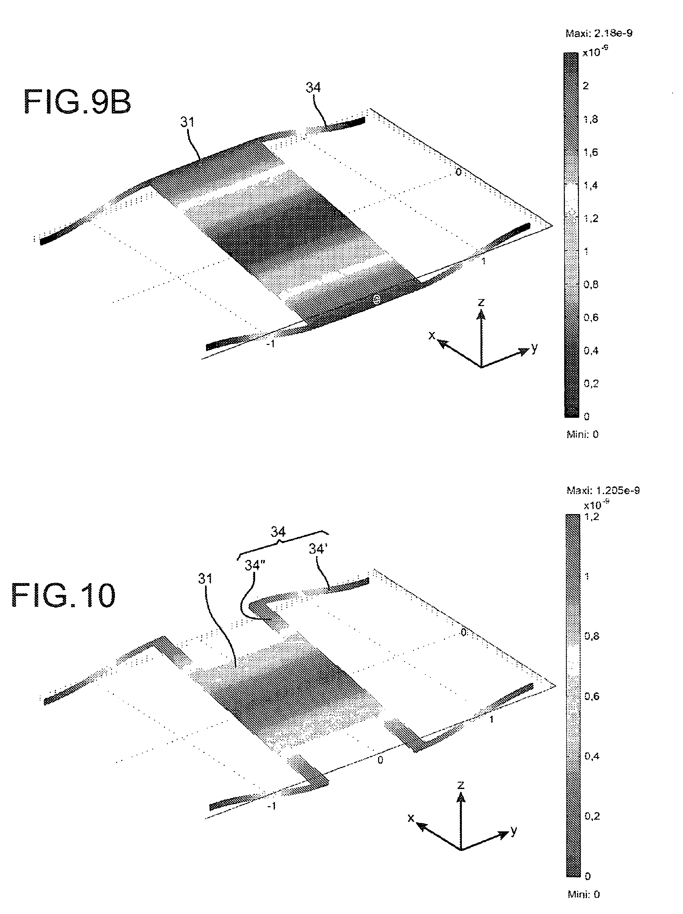

Au contraire, comme illustré sur les figures 9A et 9B, si on augmente la dimension de la masse déformable 31 selon l'axe x, c'est-à-dire transversalement à l'axe des bras élastiques 34, la force F reste sensiblement identique mais le déplacement latéral dx est augmenté, tous les autres paramètres étant inchangés par ailleurs. Sur les figures 9A, 9B les dimensions de la masse déformable 31 deviennent 200x100x5 micromètres au cube.

Sur la figure 9A, on obtient un déplacement latéral dx = 4,7 nanomètres et sur la figure 9B une flèche zmax de 2,2 nanomètres lorsque le champ magnétique est dirigé selon l'axe x.

Sur la figure 10, le capteur selon l'invention possède deux paires de bras élastiques 34 dont les points d'ancrage à la partie fixe 33 sont plus éloignés que dans les deux cas précédents illustrés aux figures 8 et 9.

Les tronçons principaux 34' dirigés selon l'axe y des bras élastiques 34 valent toujours 100x1x5 micromètres au cube mais ces tronçons principaux 34' sont raccordés à des tronçons additionnels 34 " orientés sensiblement selon l'axe x. Le déplacement latéral de la masse déformable 31 n'est pas modifié, mais cela n'est pas illustré. Deux tronçons principaux 34' orientés selon l'axe y reliés à un même côté de la partie fixe 33 sont espacés au niveau de leur point d'ancrage de 200 micromètres alors que dans la configuration de la figure 8, cet espacement n'était que de 100 micromètres. On a voulu montrer sur la figure 10 que la flèche maximale zmax obtenue avec un champ magnétique orienté selon l'axe x a diminué de manière significative au niveau du point de mesure. Elle ne vaut plus que sensiblement 0,6 nanomètre. Une telle configuration permet de rendre le capteur selon l'invention moins sensible au couple sans dégrader sa sensibilité au gradient de champ.

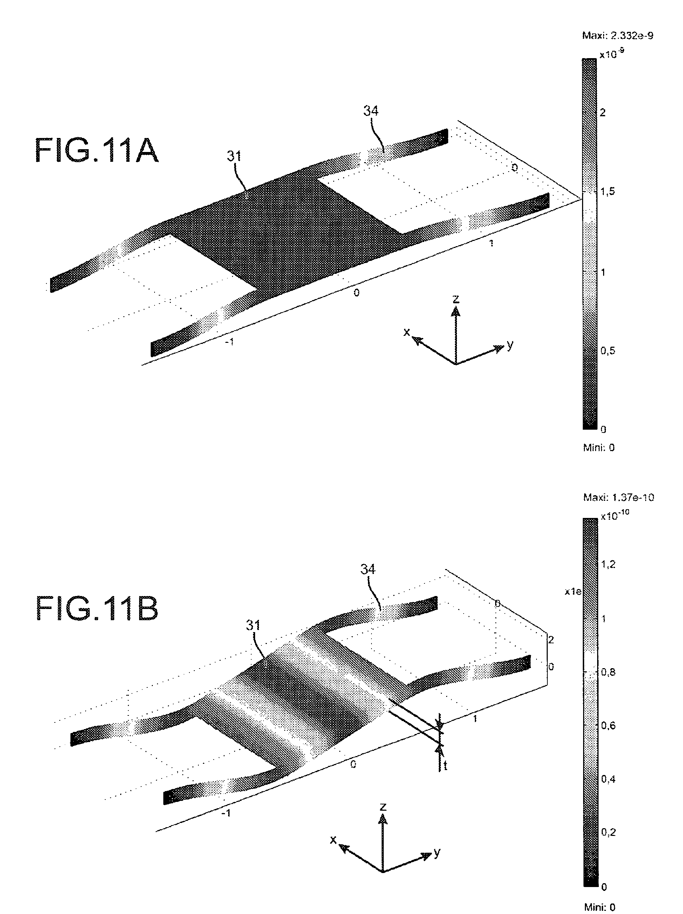

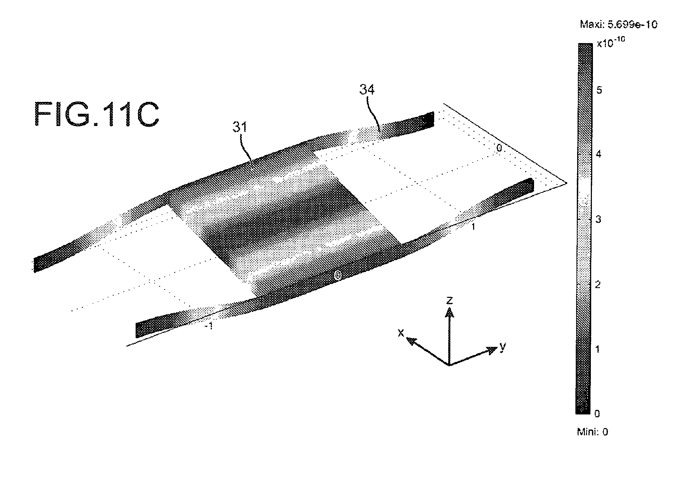

Sur les figures 11A, 11B, 11C, on a voulu montrer l'influence de l'épaisseur de la masse déformable 31 et de celle des bras élastiques 34.

On a doublé l'épaisseur t des bras élastiques 34 et de la masse déformable 31, cette épaisseur est passée de 5 micromètres à 10 micromètres, les deux autres dimensions étant inchangées.

En augmentant l'épaisseur t des bras élastiques sans toucher à leur largeur w, on augmente le rapport kz/kx avec kz raideur selon l'axe z des bras élastiques 34 et kx raideur selon l'axe x, puisque $kx/kz = (t/w)^2$. On cherche à augmenter le plus possible ce rapport des raideurs kx/kz de manière à ce que le déplacement latéral dx dû au gradient de champ magnétique soit le plus grand possible par rapport à la flèche engendrée par un champ magnétique dirigé selon l'axe x. En conclusion, on rend moins sensible la masse déformable 31 au champ magnétique sans modifier sa sensibilité au gradient de champ magnétique. Le déplacement latéral dx de la masse déformable est toujours de 2,35 nm alors la flèche maximale zmax engendrée par un champ magnétique orienté selon l'axe y vaut 0,14 nm (figure 11B) et celle zmax engendrée par un champ magnétique orienté selon l'axe x vaut seulement 0,6 nm (figure 11C).

Le capteur selon l'invention peut également servir à distinguer une contribution due à un gradient de champ magnétique de celle due à une accélération à laquelle serait soumis le capteur. Éventuellement, le capteur objet de l'invention peut mesurer les deux grandeurs physiques en même temps.

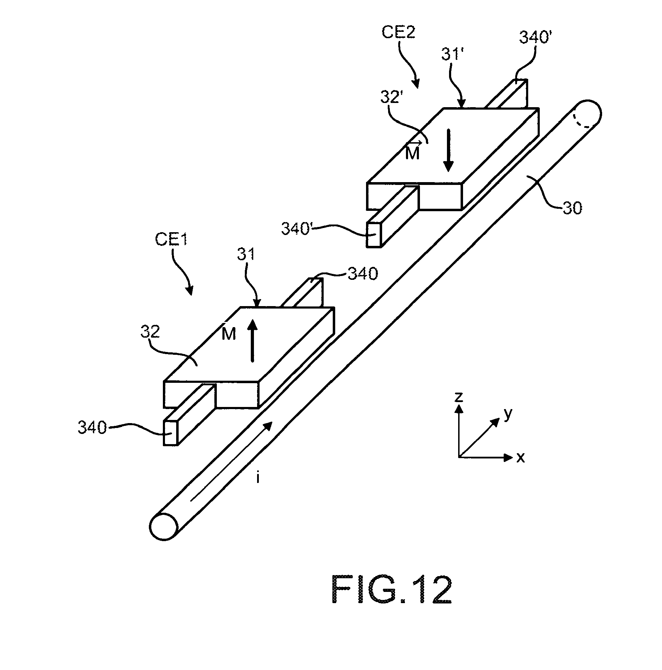

On se réfère à la figure 12. Dans cette configuration, le capteur comporte deux capteurs élémentaires CE1, CE2 conformes à ceux décrits précédemment mis bout à bout (mais sans contact), et les aimants 32, 32' des deux capteurs élémentaires CE1, CE2 sont aimantés en sens inverses. Les forces exercées sur les deux masses déformables 31, 31' des deux capteurs élémentaires CE1, CE2 seront également en sens inverses. Par contre, une accélération crée des forces dans le même sens sur les masses déformables 31, 31'. La somme des signaux délivrés par les moyens de mesure différentielle (non représentés) des deux capteurs élémentaires traduit l'accélération à laquelle le capteur est soumis tandis que la différence des deux signaux traduit le gradient de champ magnétique. On prévoit de plus un circuit additionneur et/ou soustracteur qui reçoit la sortie des moyens de mesure différentielle de chacun des capteurs élémentaires. Ce circuit additionneur et/ou soustracteur n'est pas représenté.

Sur la figure 12, le gradient de champ magnétique est créé par la circulation d'un courant dans un conducteur filaire 30 sensiblement cylindrique dirigé sensiblement dans le même axe que les bras élastiques 340, 340' qui suspendent la masse déformable 31, 31' de chacun des capteurs élémentaires CE1, CE2 par rapport à des parties fixes (non représentées). Les deux capteurs élémentaires CE1, CE2 sont placés tous les deux le long de l'axe du conducteur filaire 30 (axe y).

On va maintenant s'intéresser à un procédé de fabrication d'un capteur de gradient d'une composante d'un champ magnétique conforme à l'invention. On va plus particulièrement s'intéresser à un exemple ne comportant qu'un seul capteur élémentaire dont la masse déformable est munie de bras élastiques et dont les moyens de mesure de la grandeur électrique traduisant la contrainte ou la déformation de la masse déformable engendrée par le gradient de la grandeur électrique sont différentiels. Des explications complémentaires ponctuelles seront données pour le cas où le capteur comporte deux capteurs élémentaires avec des aimants à directions d'aimantation inversées et pour le cas où la masse déformable est directement ancrée au dispositif de support.

Avec la structure décrite précédemment, on peut réaliser aussi bien des capteurs macroscopiques que des capteurs miniatures à l'échelle micrométrique ou nanométrique. De tels capteurs miniatures peuvent aussi bien être réalisés dans des technologies connues sous la dénomination SoC ou SiP. La première technologie citée signifie System on Chip soit système sur puce et la seconde System in package soit système dans un boîtier.

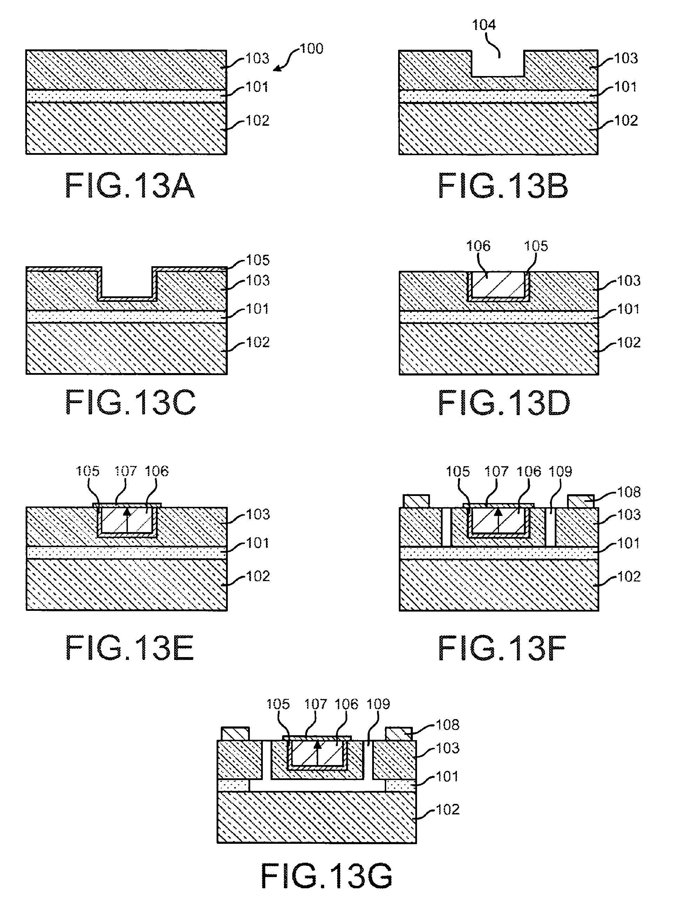

On part d'un substrat de base 100 comportant une couche sacrificielle 101, en matériau isolant électriquement enterrée, c'est-à-dire prise en sandwich entre deux couches de matériau semi-conducteur 102, 103 (figure 13A). Il peut s'agir avantageusement d'un substrat SOI (silicon ion insulator ou silicium sur isolant). On se réfère à la figure 13A. Un tel substrat 100 comporte deux couches de silicium prenant en sandwich une couche électriquement isolante.

On peut réaliser sur ce substrat de base 100 un ou plusieurs capteurs élémentaires décrits précédemment .

Dans la suite de la description, on va faire comme si on ne réalisait qu'un seul capteur élémentaire. Mais cela ne pose aucun problème d'étendre les différentes étapes décrites ci-dessous de manière à réaliser simultanément sur le même substrat de base 100 plusieurs capteurs élémentaires. Plusieurs capteurs élémentaires peuvent rester solidaires du même substrat de base 100 notamment dans le cas de réalisation d'un capteur de gradient d'une composante d'un champ magnétique apte à mesurer une accélération. Dans d'autres applications, les capteurs élémentaires sont dissociés les uns des autres par découpe en morceaux du substrat de base 100.

On commence par creuser dans l'une des couches en matériau semi-conducteur 103, dite couche superficielle, au moins un caisson 104 devant accueillir un aimant d'une masse déformable (figure 13B). La profondeur du caisson 104 est inférieure à l'épaisseur de la couche superficielle 103. Cela signifie que le fond du caisson 104 se trouve dans le matériau de la couche superficielle 103 en matériau semi-conducteur et ne met pas à nu la couche sacrificielle 101. Le caisson 104 peut se faire avec une gravure sèche par exemple de type RIE acronyme anglophone de Reactive Ion Etching soit gravure par ions réactifs.

La profondeur du caisson 104 ne sera que de 4 micromètres, par exemple, si l'épaisseur de la couche superficielle 103 est de 5 micromètres.

On dépose en surface une sous-couche 105 de manière à ce qu'elle tapisse le fond et les flancs du caisson 104 (figure 13C). Cette sous-couche 105 a pour fonction d'assurer l'adhésion de la couche de matériau magnétique du futur aimant permanent et d'éviter une diffusion du matériau semi-conducteur dans laquelle est creusé le caisson dans le matériau magnétique lors d'une éventuelle étape future de recuit de cristallisation. Cette sous-couche barrière 105 peut être réalisée à base de tantale Ta, de tungstène W, de nitrure de tungstène et être déposée par dépôt physique en phase vapeur, connu sous l'acronyme anglophone PVD pour Physical Vapor Deposition.

On réalise ensuite chaque aimant permanent. Pour cela, on dépose en surface une couche en matériau magnétique 106, par exemple, un alliage néodyme fer bore, samarium cobalt ou tout alliage de terres rares et de métaux de transition présentant des propriétés de matériaux magnétiques durs (figure 13D). Ce dépôt de matériau magnétique peut se faire par dépôt PVD. La couche en matériau magnétique 106 est suffisamment épaisse pour remplir le caisson 104. La couche en matériau magnétique peut 106 avoir une épaisseur d'environ 5 micromètres. Au lieu de réaliser un dépôt PVD, il est possible de recourir à un dépôt électrolytique avec des alliages de type cobalt platine par exemple.

On procède ensuite à une étape de polissage mécano chimique de la couche en matériau magnétique 106 avec arrêt en surface de la couche superficielle en matériau semi-conducteur 103. Le matériau magnétique est conservé dans chaque caisson 104.

On recouvre l'ensemble d'une couche de passivation 107, par exemple par PVD. Cette couche de passivation 107 peut être réalisée à base réalisée à base de tantale Ta, de tungstène W, de nitrure de tungstène. Par une étape de lithographie suivie d'une gravure sèche ou humide, on conserve cette couche de passivation 107 au dessus de l'aimant 32, et on l'élimine ailleurs (figure 13E). On peut bien sûr la faire dépasser un peu le contour de l'aimant.

On va procéder ensuite à l'aimantation de l'aimant 32. Il est préférable de prévoir une étape de recuit préalable du matériau magnétique 106 de manière à cristalliser le matériau magnétique dans le cas où la couche en matériau magnétique 106 est amorphe ou magnétiquement douce après le dépôt. Le recuit peut se faire à environ 750°C pendant une dizaine de minutes sous vide pour les alliages néodyme fer bore. L'aimantation ultérieure peut se faire par exposition à un champ magnétique intense par exemple de plusieurs Teslas délivré par un électroaimant ou une bobine supraconductrice (non représentés).

On va ensuite réaliser des contacts électriques pour les parties fixes 33 et les moyens de mesure de la grandeur électrique traduisant la contrainte ou du déplacement 35. Les contacts électriques des moyens de mesure 35 sont référencés 108 et ceux des parties fixes 33 s'appellent 108'. Dans l'exemple décrit, les parties fixes 33 sont portées à la masse. On suppose que dans cet exemple, les moyens de mesure sont des moyens de mesure différentielle, qu'ils sont de type capacitifs et sont formés d'au moins une paire d'électrodes en vis-à-vis de part et d'autre de la masse déformable. La délimitation des ces éléments n'a pas encore eu lieu à ce stade. Pour cela on dépose en surface une couche de matériau électriquement conducteur par exemple du siliciure d'aluminium AlSi. Par une étape de gravure par exemple chimique, on délimite le contour des contacts ) électriques 108 (figure 13F).

On va ensuite délimiter le contour de la masse déformable 31 et des points d'ancrage de la masse déformable au dispositif de support, des bras élastiques 34 s'ils existent, du dispositif de support 33. On délimite aussi les électrodes 35.1, 35.2 de mesure de la déformation latérale de la masse déformable 31, si elles existent.

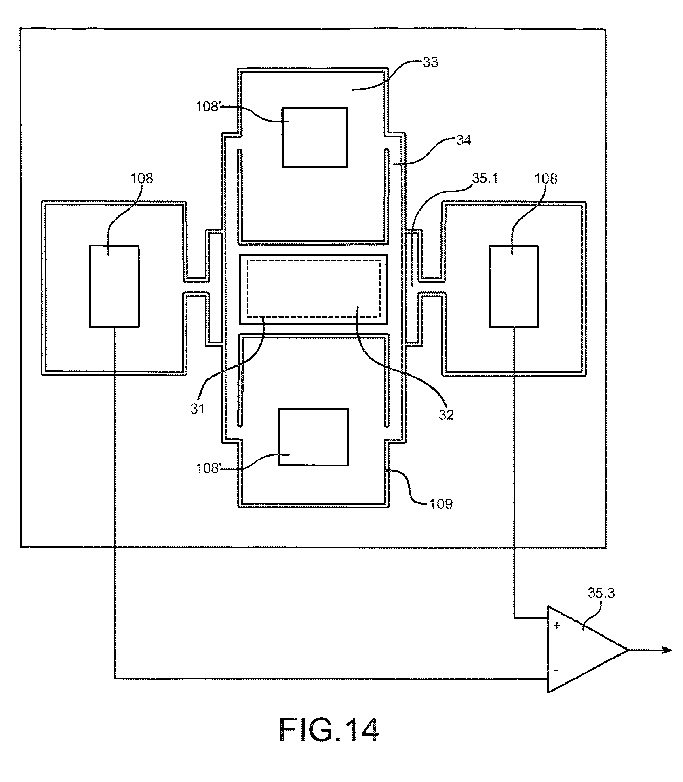

On va pour cela creuser au moins une tranchée 109 au contour de ces éléments dans la couche de matériau semi-conducteur superficielle 103. Cette tranchée 109 peut être réalisée par gravure sèche DRIE acronyme anglais pour Deep Reactive Ion Etching c'est-à-dire gravure ionique réactive profonde. Le fond de la tranchée 109 s'arrête sur la couche isolante 101 du substrat de base (figure 13F). La tranchée 109 est bien visible sur la figure 14.

On va ensuite libérer la masse déformable 31 et le dessous des électrodes 35.1, 35.2 et des bras élastiques 34 mais pas l'ancrage aux dispositifs de support 33 et le dispositif de support 33 proprement dit. Cette libération se fait en éliminant le matériau sacrificiel 101 enterré se trouvant sous la masse déformable 31, les bras élastiques 34 et les électrodes 35.1, 35.2 (s'ils existent) (figure 13G). On laisse la couche sacrificielle 101 ailleurs. Cela peut se faire par gravure humide à l'acide fluorhydrique. Il ne reste plus qu'à relier les contacts électriques 108 des moyens de mesure de la grandeur électrique traduisant la contrainte ou la déformation de la masse déformable engendrée par le gradient de la grandeur électrique à un amplificateur différentiel 35.3 schématisé sur la figure 14.

Si on réalise un capteur de gradient apte à mesurer également une accélération comme illustré à la figure 12, puisque les deux aimants permanents des deux capteurs élémentaires ont des directions d'aimantation opposées, il n'est plus possible de prévoir une étape d'aimantation par exposition à un même champ magnétique intense comme décrit précédemment. Par contre on peut recourir à une étape d'écriture magnétique thermiquement assistée. Ce concept est décrit, étudié et réalisé dans le document [6].

Bien que plusieurs modes de réalisation de la présente invention aient été représentés et décrits de façon détaillée, on comprendra que différents changements et modifications puissent être apportés sans sortir du cadre de l'invention.

Les différentes variantes décrites doivent être comprises comme n'étant pas forcément exclusives les unes des autres.

## DOCUMENTS CITES

**[1]** US 3 829 768

**[2]** « Induction coil sensors - a review » S. Tumanski, Measurement Science and Technology, vol. 18, R 31-46, 2007

**[3]** « Magnetic gradiometry: a new method for magnetic gradient measurement » A. Veryaskin, Sensors and Actuators, vol 91, pages 233-235, 2001

**[4]** « Fiber-optic magnetic gradiometer utilizing the magnetic translational force » H. Okamura, Journal of Lightwave Technology, vol 8(6), pages 877-882, 1990

**[5]** « Design of a MEMS passive, proximity-based AC electric current sensor for residential and commercial loads » E. Leland et al., PowerMEMS 2007, Berkeley, California

**[6]** « Thermomagnetic writing in Tb-Fe : Modeling and comparison with experiment » J. C. Suits et al., Journal of Applied Physics, vol 64(1), pages 252-261, 1988.

## Revendications

1. Capteur de gradient d'une composante d'un champ magnétique comportant au moins un capteur élémentaire comprenant une masse déformable (31) équipée d'un aimant permanent (32) ayant une direction d'aimantation sensiblement colinéaire à la direction du gradient de la composante du champ magnétique à acquérir par le capteur, **caractérisé en ce que** la masse déformable (31) est apte à se déformer sous l'effet d'une force induite sur l'aimant par le gradient, cette force ayant pour effet de le déplacer, en entraînant la masse déformable (31), dans une

EP 2 226 643 B1

direction sensiblement colinéaire à la composante du champ magnétique pour laquelle le capteur a à acquérir le gradient, la masse déformable (31) étant ancrée à un dispositif de support (33) fixe en au moins deux points d'ancrage (36) sensiblement opposés par rapport à la masse (31), le capteur élémentaire comportant en outre des moyens de mesure (35, 35.1, 35.2, 35.3) d'au moins une grandeur électrique traduisant une déformation ou une contrainte de la masse déformable (31) engendrée par le gradient.

2. Capteur selon la revendication 1, dans lequel la masse déformable (31) s'étend au repos sensiblement dans un plan (x, y) et dans lequel la direction d'aimantation (M) de l'aimant permanent (32) est sensiblement normale au plan (x, y).

3. Capteur selon l'une des revendications 1 ou 2, dans lequel un point d'ancrage (36) de la masse déformable (31) est relié directement au dispositif de support ou indirectement par l'intermédiaire d'un bras élastique (34).

4. Capteur selon la revendication 2 et la revendication 3, dans lequel la masse déformable (31) est suspendue par rapport au dispositif de support (33) à l'aide d'au moins deux bras élastiques (34) dirigés sensiblement dans le plan de la masse déformable.

5. Capteur selon l'une des revendications 1 à 4, dans lequel les bras élastiques (34) comportent au moins un tronçon principal (34'), deux bras élastiques (34) formant une paire possédant des tronçons principaux (34') situés dans le prolongement l'un de l'autre.

6. Capteur selon la revendication 5, dans lequel le déplacement de l'aimant (32) se fait selon un axe du plan (x,y), sensiblement normal à l'axe des tronçons principaux (34').

7. Capteur selon la revendication 5, dans lequel lorsque le capteur élémentaire comporte deux paires (P1, P2) de bras élastiques (34), les points d'ancrage (36) de la masse déformable auxquels sont reliés deux bras élastiques n'appartenant pas à la même paire sont les plus éloignés possible et/ou les points d'ancrage (36) de la masse déformable (31) auxquels sont reliés les bras élastiques (34) des deux paires (P1, P2) sont placés symétriquement par rapport à un axe de symétrie (y1) de la masse déformable (31).

8. Capteur selon l'une des revendications 3 à 7, dans lequel les bras élastiques (34) ont une épaisseur et une largeur, leur épaisseur étant supérieure à leur largeur pour être plus rigides selon des directions sensiblement orthogonales à la direction de la force induite sur l'aimant par le gradient.

9. Capteur selon la revendication 5, dans lequel chaque bras élastique (34) comporte un tronçon additionnel (34") relié au tronçon principal (34') et agencé de manière que deux points d'ancrage voisins (36) de la masse déformable (31) auxquels sont reliés deux bras élastiques (34) de paires différentes (P1, P2) sont moins éloignés que des points d'ancrage (37) aux quels sont reliés ces bras élastiques (34) sur le dispositif de support (33).

10. Capteur selon la revendication 5, dans lequel lorsque le capteur élémentaire comporte une seule paire (P1) de bras élastiques (34), l'axe (y) des tronçons principaux (34') des bras élastiques (34) est confondu avec un axe de symétrie (y1) de la masse déformable (31).

11. Capteur selon l'une des revendications précédentes, dans lequel les moyens de mesure (35) d'au moins une grandeur électrique traduisant la déformation ou la contrainte de la masse déformable (31) engendrée par le gradient sont différentiels, ils sont capacitifs ou comportent au moins une paire de jauges de contrainte (35.6, 35.7).

12. Capteur selon l'une des revendications précédentes, comportant de plus des moyens d'excitation (40) de la masse déformable (31) pour la faire vibrer, ces moyens d'excitation (40) étant notamment électrostatiques, piézoélectriques ou magnétiques.

13. Capteur selon la revendication 12, dans lequel la masse déformable (31) présente une déformation qui est non linéaire en fonction de la force qui s'applique sur l'aimant (32) due au gradient.

14. Capteur selon l'une des revendications précédentes, comportant deux capteurs élémentaires (CE1, CE2) dans lesquels les aimants (32, 32') des masse déformables (31, 31') ont des directions d'aimantation opposées de manière à pouvoir distinguer une accélération du gradient de la composante de champ magnétique et à éventuellement mesurer l'accélération et le gradient en même temps.

13

**15.** Procédé de fabrication d'un capteur d'un gradient d'une composante d'un champ magnétique, comportant les étapes consistant à :

fournir un substrat de base (100) comportant une couche sacrificielle (101) enterrée sous une couche superficielle (103) en matériau semi-conducteur,

creuser au moins un caisson (104) dans la couche superficielle (103) sans atteindre la couche sacrificielle (101), ce caisson étant destiné à loger un aimant permanent devant être incorporé dans une masse déformable délimitée ultérieurement dans la couche superficielle,

remplir le caisson de matériau magnétique (106) et aimanter le matériau magnétique dans le caisson

former des contacts métalliques (108) sur la couche superficielle (103) destinés à des moyens de mesure d'au moins une grandeur électrique traduisant une déformation ou une contrainte de la masse déformable engendrée par le gradient, ce gradient étant sensiblement colinéaire à la direction de l'aimantation de l'aimant,

graver dans la couche superficielle une ou plusieurs tranchées (109) mettant à nu la couche sacrificielle (101) de manière à délimiter le contour de la masse déformable et d'au moins deux points d'ancrage de la masse déformable à un dispositif de support fixe, ces deux points étant opposés par rapport à la masse déformable,

éliminer la couche sacrificielle sous la masse déformable pour la libérer de manière à ce que les points d'ancrage restent reliés au dispositif de support.

## Claims

**1.** A gradient sensor of a component of a magnetic field comprising at least one elementary sensor comprising a deformable mass (31) equipped with a permanent magnet (32) having a magnetization direction substantially colinear to the direction of the gradient of the component of the magnetic field to be acquired by the sensor, **characterized in that** the deformable mass (31) is able to deform under the effect of a force exerted on the magnet by the gradient, the effect of said force being to shift it, by dragging the deformable mass (31), in a direction substantially colinear to the component of the magnetic field for which the sensor has to acquire the gradient, the deformable mass (31) being anchored to a fixed support device (33) in at least two anchoring points (36) substantially opposite relative to the mass (31), the elementary sensor also comprising measuring means (35, 35.1, 35.2, 35.3) of at least one electric variable translating deformation or stress of the deformable mass (31) engendered by the gradient.

**2.** The sensor as claimed in Claim 1, wherein the deformable mass (31) extends at rest substantially in a plane (x, y) and wherein the magnetising direction (M) of the permanent magnet (32) is substantially normal to the plane (x, y).

**3.** The sensor as claimed in any one of Claims 1 or 2, wherein an anchoring point (36) of the deformable mass (31) is connected directly to the support device or indirectly by means of an elastic arm (33) .

**4.** The sensor as claimed in Claim 2 and Claim 3, wherein the deformable mass (31) is suspended relative to the support device (33) by means of at least two elastic arms (34) directed substantially in the plane of the deformable mass.

**5.** The sensor as claimed in any one of Claims 1 to 4, wherein the elastic arms (34) comprise at least one main section (34'), two elastic arms (34) forming a pair having main sections (34') located in the extension of one another.

**6.** The sensor as claimed in Claim 5, wherein the magnet (32) is shifted according to an axis of the plane (x,y), substantially normal to the axis of the main sections (34').

**7.** The sensor as claimed in Claim 5, wherein when the elementary sensor comprises two pairs (P1, P2) of elastic arms (34), the anchoring points (36) of the deformable mass to which are connected two elastic arms not belonging to the same pair are as far away as possible and/or the anchoring points (36) of the deformable mass (31) to which are connected the elastic arms (34) of the two pairs (P1, P2) are placed symmetrically relative to an axis of symmetry (y1) of the deformable mass (31).

**8.** The sensor as claimed in any one of Claims 3 to 7, wherein the elastic arms (34) have a thickness and a width, their thickness being greater than their width to be more rigid according to directions substantially orthogonal to the direction of the force exerted on the magnet by the gradient.

**9.** The sensor as claimed in Claim 5, wherein each elastic arm (34) comprises an additional section (34") connected to the main section (34') and arranged in such a way that two adjacent anchoring points (36) of the deformable mass (31) to which are connected two elastic arms (34) of different pairs (P1, P2) are less distant than anchoring points (37) to which are connected said elastic arms (34) on the support device (33).

**10.** The sensor as claimed in Claim 5, wherein when the elementary sensor comprises a single pair (P1) of elastic arms (34), the axis (y) of the main sections (34') of the elastic arms (34) is merged with an axis of symmetry (y1) of the deformable mass (31) .

**11.** The sensor as claimed in any one of the preceding claims, wherein the measuring means (35) of at least one electric variable translating the deformation or the stress of the deformable mass (31) engendered by the gradient are differential, they are capacitive or comprise at least one pair of strain gauges (35.6, 35.7).

**12.** The sensor as claimed in any one of the preceding claims, further comprising excitation means (40) of the deformable mass (31) to make it vibrate, these excitation means (40) being especially electrostatic, piezoelectric or magnetic.

**13.** The sensor as claimed in Claim 12, wherein the deformable mass (31) exhibits a deformation which is non linear as a function of the force applied to the magnet (32) due to the gradient.

**14.** The sensor as claimed in any one of the preceding claims, comprising two elementary sensors (CE1, CE2) in which the magnets (32, 32') of the deformable masses (31, 31') have magnetization directions opposed so as to be able to distinguish acceleration of the gradient of the magnetic field component and optionally measure acceleration and gradient at the same time.

**15.** A manufacturing process of a gradient sensor of a component of a magnetic field, comprising steps consisting of:

providing a base substrate (100) comprising a sacrificial layer (101) embedded under a superficial layer (103) made of semi-conductor material,
hollowing at least one caisson (104) in the superficial layer (103) without reaching the sacrificial layer (101), this caisson being intended to house a permanent magnet before being incorporated in a deformable mass delimited later in the superficial layer,
filling the caisson with magnetic material (106) and magnetising the magnetic material in the caisson
forming metallic contacts (108) on the superficial layer (103) intended for measuring means of at least one electric variable translating deformation or stress of the deformable mass engendered by the gradient, this gradient being substantially colinear to the magnetization direction of the magnet,
etching in the superficial layer one or more trenches (109) revealing the sacrificial layer (101) so as to delimit the contour of the deformable mass and of at least two anchoring points of the deformable mass to a fixed support device, these two points being opposite relative to the deformable mass,
eliminating the sacrificial layer under the deformable mass to release it so that the anchoring points remain connected to the support device.

**Patentansprüche**

**1.** Sensor für einen Gradienten einer Komponente eines Magnetfelds, umfassend wenigstens einen Elemenfiarsensor, der eine deformierbare Masse (31) umfasst, welche mit einem Permanentmagneten (32) ausgestattet ist, der eine Magnetisierungsrichtung aufweist, die im Wesentlichen kollinear zu der Richtung des von dem Sensor aufzunehmenden Gradienten der Komponente des Magnetfelds ist, **dadurch gekennzeichnet dass** die deformierbare Masse (31) dazu geeignet ist, sich unter der Wirkung einer Kraft zu verformen, welche durch den Gradienten auf den Magneten induziert wird, wobei die Kraft die Wirkung hat, diesen zu verlagern, wobei die deformierbare Masse (31) mitgenommen wird, in eine Richtung im Wesentlichen kollinear zu der Komponente des Magnetfelds, für welche der Sensor den Gradienten aufnehmen soll, wobei die deformierbare Masse (31) an einer festen Halfierungseinrichfiung (33) an wenigstens zwei Verankerungspunkten (36) verankert ist, die einander in Bezug zu der Masse (31) im Wesentlichen gegenüberliegen, wobei der Elemenfiarsensor weiterhin Messmittel (35, 35.1, 35.2, 35.3) für wenigstens eine elektrische Größe umfasst, welche eine Deformation oder eine Beanspruchung der deformierbaren Masse (31) ausdrückt, die durch den Gradienten erzeugt wird.

**2.** Sensor nach Anspruch 1, wobei die deformierbare Masse (31) sich in Ruhe im Wesentlichen in einer Ebene (x, y) erstreckt, und wobei die Magnetisierungsrichtung (M) des Permanentmagneten (32) im Wesentlichen normal zur Ebene (x, y) ist.

**3.** Sensor nach einem der Ansprüche 1 oder 2, wobei ein Verankerungspunkt (36) der deformierbaren Masse (31) direkt mit der Halterungseinrichtung verbunden ist, oder indirekt unter Vermittlung eines elastischen Arms (34).

**4.** Sensor nach Anspruch 2 und Anspruch 3, wobei die deformierbare Masse (31) in Bezug auf die Halterungseinrichtung (33) mit Hilfe von wenigstens zwei elastischen Armen (34) aufgehängt ist, die im Wesentliche in der Ebene der deformierbaren Masse ausgerichtet sind.

**5.** Sensor nach einem der Ansprüche 1 bis 4, wobei die elastischen Arme (34) wenigstens einen Hauptabschnitt (34') umfassen, wobei zwei, ein Paar bildende elastische Arme (34) Hauptabschnitte (34') umfassen, die in der Verlängerung voreinander gelegen sind.

**6.** Sensor nach Anspruch 5, wobei die Verlagerung des Magneten (32) längs einer Achse der Ebene (x, y) erfolgt, im Wesentlichen normal zu der Achse der Hauptabschnitte (34').

**7.** Sensor nach Anspruch 5, wobei, wenn der Elementarsensor zwei Paare (P1, P2) von elastischen Armen (34) umfasst, die Verankerungspunkte (36) der deformierbaren Masse, mit welchen zwei elastische Arme verbunden sind, welche nicht zum gleichen Paar gehören, so weit wie möglich entfernt sind, und/oder die Verankerungspunkte (36) der deformierbaren Masse (31), mit welchen die elastischen Arme (34) der zwei Paare (P1, P2) verbunden sind, symmetrisch in Beziehung zu einer Symmetrieachse (y1) der deformierbaren Masse (31) positioniert sind.

**8.** Sensor nach einem der Ansprüche 3 bis 7, wobei die elastischen Arme (34) eine Dicke und eine Breite haben, wobei ihre Dicke größer ist als ihre Breite, um entlang von Richtungen im Wesentlichen orthogonal zu der Richtung der Kraft, die durch den Gradienten auf den Magneten induziert wird, steifer zu sein.

**9.** Sensor nach Anspruch 5, wobei jeder elastische Arm (34) einen Zusatzabschnitt (34") umfasst, der mit dem Hauptabschnitt (34') verbunden ist und so eingerichtet ist, dass zwei benachbarte Verankerungspunkte (36) der deformierbaren Masse (31), mit welchen zwei elastische Arme (34) von unterschiedlichen Paaren (P1, P2) verbunden sind, weniger weit entfernt sind, als Verankerungspunkte (37), mit welchen diese elastischen Arme (34) an der Halterungseinrichtung (33) verbunden sind.

**10.** Sensor nach Anspruch 5, wobei, wenn der Elementarsensor ein einzelnes Paar (P1) von elastischen Armen (34) umfasst, die Achse (y) der Hauptabschnitte (34') der elastischen Arme (34) mit einer Symmetrieachse (y1) der deformierbaren Masse (31) zusammenfällt.

**11.** Sensor nach einem der vorhergehenden Ansprüche, wobei die Messmittel (35) für wenigstens eine elektrische Größe, welche die Deformation oder Beanspruchung der deformierbaren Masse (31) ausdrückt, die durch den Gradienten erzeugt wird, differenziell sind, sie sind kapazitiv oder umfassen wenigstens ein Paar von Beanspruchungs-Messeinrichtungen (35.6, 35.7).

**12.** Sensor nach einem der vorhergehenden Ansprüche, weiterhin umfassend Anregungsmittel (40) für die deformierbare Masse (31), um diese zum Vibrieren zu bringen, wobei die Anregungsmittel (40) insbesondere elektrostatisch, piezoelektrisch oder magnetisch sind.

**13.** Sensor nach Anspruch 12, wobei die deformierbare Masse (31) eine Deformation aufweist, die als Funktion der Kraft, welche aufgrund des Gradienten auf den Magneten (32) wirkt, nichtlinear ist.

**14.** Sensor nach einem der vorhergehenden Ansprüche, umfassend zwei Elementarsensoren (CE1, CE2), wobei die Magneten (32, 32') der deformierbaren Massen (31, 31') Magnetisierungsrichfiungeo haben, die entgegengesetzt sind, um eine Beschleunigung des Gradienten der Komponente des Magnetfelds erkennen zu können, und um gegebenenfalls die Beschleunigung und den Gradienten gleichzeitig messen zu könnten.

**15.** Verfahren zur Herstellung eines Sensors für einen Gradienten einer Komponente eines Magnetfelds, umfassend die Schritte die darin bestehen:

ein Basis-Substrat (100) bereitzustellen, welches eine Opferschicht (101) umfasst, welche unter einer Oberflächenschicht (103) aus einem Halbleiter-Material begraben ist,

wenigstens eine Aufnahme (caisson) (104) in die Oberflächenschicht (103) zu graben, ohne die Opferschicht (101) zu erreichen, wobei die Aufnahme dazu bestimmt ist, einen Permanentmagneten aufzunehmen, bevor sie in eine deformierbare Masse eingebaut wird, welche später in der Oberflächenschicht abgegrenzt wird,
die Aufnahme mit einem magnetischen Material (106) zu füllen und das magnetische Material in der Aufnahme zu magnetisieren,
metallische Kontakte (108) auf der Oberflächenschicht (103) zu bildern, die als Messmittel für wenigstens eine elektrische Größe bestimmt sind, welche eine Deformation oder eine Beanspruchung der deformierbaren Masse ausdrückt, die durch den Gradienten erzeugt wird, wobei dieser Gradient im Wesentlichen kollinear zu der Magnetisierungsrichtung des Magneten ist,
in die Oberflächenschicht einen oder mehrere Gräben (109) einzugraben, welche die Opferschicht (101) freilegen, derart, dass die Kontur von der deformierbaren Masse und von wenigstens zwei Verankerungspunkten der deformierbaren Masse an einer festen Halterungseinrichtung abgegrenzt wird, wobei diese zwei Punkte in Bezug auf die deformierbare Masse einander gegenüber liegen,
die Opferschicht unter der deformierbaren Masse zu eliminieren, um diese derart zu befreien, dass die Verankerungspunkte mit der Halterungseinrichtung verbunden bleiben.

FIG.1A

FIG.1B

FIG.1C

Maxi: 3.436e-7

$\times 10^{-7}$

Z$_{grad}$=350nm

3

2,5

2

1,5

1

0,5

z

y x

0

Mini: 0

# FIG.2A

Maxi: 5.538e-7

$\times 10^{-7}$

Z$_{champ}$=550nm

champ

5

4

3

2

1

z

y x

0

Mini: 0

# FIG.2B

FIG.3

FIG.4A

FIG.4B

FIG.4C

# FIG.5

$V_{dc}-V_{ac}$

$V_{dc}+V_{ac}$

FIG.6

# FIG.7

FIG.8A

FIG.8B

FIG.8C

Maxi: 2.148e-9

FIG.9A

Maxi: 4,712e-9

FIG.9B

Maxi: 2.18e-9
x10⁻⁹
Mini: 0

FIG.10

Maxi: 1.205e-9
x10⁻⁹
Mini: 0

FIG.11A

FIG.11B

FIG.11C

FIG.12

FIG.13A

FIG.13B

FIG.13C

FIG.13D

FIG.13E

FIG.13F

FIG.13G

FIG.14

FIG.15A

FIG.15B

FIG.15C

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20030020472 A
- WO 2005062064 A
- WO 0167122 A
- US 3829768 A

**Littérature non-brevet citée dans la description**

- **S. Tumanski.** Induction coil sensors - a review. *Measurement Science and Technology,* 2007, vol. 18, R 31-46
- **A. Veryaskin.** Magnetic gradiometry: a new method for magnetic gradient measurement. *Sensors and Actuators,* 2001, vol. 91, 233-235
- **H. Okamura.** Fiber-optic magnetic gradiometer utilizing the magnetic translational force. *Journal of Lightwave Technology,* 1990, vol. 8 (6), 877-882
- **E. Leland et al.** Design of a MEMS passive, proximity-based AC electric current sensor for residential and commercial loads. *PowerMEMS,* 2007
- **J. C. Suits et al.** Thermomagnetic writing in Tb-Fe : Modeling and comparison with experiment. *Journal of Applied Physics,* 1988, vol. 64 (1), 252-261